# EUROPEAN PATENT APPLICATION

(11) **EP 4 597 540 A1**
(43) Date of publication of application: **06.08.2025**
(21) Application number: 24154603.5
(22) Date of filing: 30.01.2024
(51) Int. Cl.: H01J 37/28

(54) **CHARGED PARTICLE-OPTICAL APPARATUS AND METHOD OF PROCESSING A SAMPLE**

(71) Applicant: ASML Netherlands B.V., 5500 AH Veldhoven (NL)
(72) Inventor: WIELAND, Marco, Jan-Jaco, 5500 AH Veldhoven (NL); MAASSEN, Martinus, Gerardus, Johannes, Maria, 5500 AH Veldhoven (NL); SLOT, Erwin, 5500 AH Veldhoven (NL); TSIATMAS, Anagnostis, San Jose, CA 95134 (US)
(74) Representative: ASML Netherlands B.V.

(57) **Abstract**

A charged particle-optical apparatus comprises: a charged particle-optical device configured to direct a beam grid of beams of charged particles toward a region of a sample surface of a sample; a sample support configured to support the sample; and a controller configured to control the charged particle-optical apparatus to selectively apply one of a plurality of predetermined beam area patterns so as to process portions of respective beam areas of the region with respective beams in accordance with the applied beam area pattern; wherein the beam area patterns are associated with respective proportions of the beam areas being processed, and at least one of the beam area patterns comprises at least one elongate strip.

## Description

### FIELD

The embodiments disclosed herein relate to charged particle-optical apparatuses and methods of processing a sample, particularly in the context of assessing a sample such as inspecting a sample, for example to identify defects.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Assessing the extent of the undesired pattern defects is therefore an important process in the manufacture of IC chips. More generally, assessment (e.g. inspection and/or measurement) of a surface of a substrate, or other object/material, is an important process during and/or after its manufacture.

Assessment apparatuses with a charged particle beam have been used to assess objects, which may be referred to as samples, for example to detect pattern defects. These apparatuses typically use electron microscopy techniques, such as a scanning electron microscope (SEM). In a SEM, a beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the beam as the probing spot over the sample surface, signal electrons can be emitted across the surface of the sample. By collecting these emitted signal electrons from the sample surface, an assessment apparatus may obtain an image representing characteristics of the material structure of the surface of the sample.

Exposing a sample to a beam of electrons so as to assess the sample can take a long time. There is a general need to reduce the time required to process a sample, for example to improve throughput.

### SUMMARY

It is an object of the present disclosure to provide embodiments that support improvement of throughput or other characteristics of charged particle-optical apparatuses.

According to an aspect of the invention, there is provided a charged particle-optical apparatus comprising: a charged particle-optical device configured to direct a beam grid of beams of charged particles toward a region of a sample surface of a sample; a sample support configured to support the sample; and a controller configured to control the charged particle-optical apparatus to selectively apply one of a plurality of predetermined beam area patterns so as to process portions of respective beam areas of the region with respective beams in accordance with the applied beam area pattern; wherein the beam area patterns are associated with respective proportions of the beam areas being processed, and at least one of the beam area patterns comprises at least one elongate strip.

According to an aspect of the invention, there is provided a method of processing a sample with beams of charged particles, the method comprising: directing a beam grid of beams of charged particles toward a sample using a charged particle-optical device; and selectively applying one of a plurality of predetermined beam area patterns so as to process portions of beam areas of a region of a sample surface of the sample with respective beams in accordance with the applied beam area pattern; wherein the beam area patterns are associated with respective proportions of the beam areas being processed, and at least one of the beam area patterns comprises at least one elongate strip.

According to an aspect of the invention, there is provided a method of processing at least a part of sample surface with a beam grid of beams of charged particles toward a region of a sample surface of a sample, each beam being assigned a beam area of the region, the method comprising: defining a pattern per beam area comprising an elongate strip; and simultaneously scanning the beams of the beam grid relative to each other so the beams scan over the respective beam areas to process a surface of the beam area corresponding to the pattern.

According to an aspect of the invention, there is provided a computer program provided in the form of media storing computer readable instructions that, when read by a computer, cause the computer to instruct a charged particle-optical apparatus to perform a method of processing a sample with beams of charged particles, the method comprising: directing a beam grid of beams of charged particles toward a sample using a charged particle-optical device; and selectively applying one of a plurality of predetermined beam area patterns so as to process portions of beam areas of a region of a sample surface of the sample with respective beams in accordance with the applied beam area pattern; wherein the beam area patterns are associated with respective proportions of the beam areas being processed, and at least one of the beam area patterns comprises at least one elongate strip.

According to an aspect of the invention, there is provided a computer program provided in the form of media storing computer readable instructions that, when read by a computer, cause the computer to instruct a charged particle-optical apparatus to perform a method of processing at least a part of a sample surface with a beam grid of beams of charged particles toward a region of a sample surface of a sample, each beam being assigned a beam area of the region, the method comprising: defining a pattern per beam area comprising an elongate strip; and simultaneously scanning the beams of the beam grid relative to each other so the beams scan over the respective beam areas to process a surface of the beam area corresponding to the pattern.

### BRIEF DESCRIPTION OF FIGURES

The above and other aspects of the present disclosure will become more apparent from the description of exemplary embodiments, taken in conjunction with the accompanying drawings.
FIG. 1 is a schematic diagram illustrating an exemplary charged particle beam assessment system.
FIG. 2 is a schematic diagram illustrating a charged particle-optical apparatus that is part of the charged particle beam assessment system of FIG. 1.
FIG. 3 is a schematic diagram of a charged particle-optical device that is part of the charged particle-optical apparatus of FIG. 2.
FIG. 4 is a schematic diagram of a charged particle-optical device that is part of the charged particle-optical apparatus of FIG. 2.
FIG. 5 is a schematic diagram of a charged particle-optical device that is part of the charged particle-optical apparatus of FIG. 2.
FIG. 6 is a schematic cross-sectional view of an objective lens array that is part of the charged particle-optical device of FIGs. 3-5.
FIG. 7 is a bottom view of the objective lens array of FIG. 6.
FIG. 8 is a schematic diagram of a data path comprising a data processing device.
FIG. 9 depicts regions of a sample surface of a sample.
FIG. 10 depicts a beam grid of beams.
FIG. 11 depicts positioning of beams in a hexagonal beam grid.
FIG. 12 depicts beam areas corresponding to beams arranged as shown in FIG. 11.
FIG. 13 depicts a beam area pattern comprising distanced elongate strips.
FIG. 14 depicts a beam area pattern comprising shortened elongate strips.
FIG. 15 depicts a beam area pattern comprising distanced and shortened elongate strips.
FIG. 16 depicts a beam area pattern comprising a deflection part.
FIG. 17 depicts a beam area pattern comprising deflection parts.
FIG. 18 depicts a beam area pattern comprising elongate strips.
FIG. 19 depicts a beam area pattern comprising differently oriented elongate strips.
FIG. 20 depicts a beam area pattern comprising an elongate strip and a deflection part.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution. For example, in an IC chip of a smart phone, which may be the size of a thumbnail and include over 2 billion transistors, the size of each transistor may need to be less than 1/1000th of a human hair. To achieve the increased resolution, semiconductor IC manufacturing has become a complex and time-consuming process, with hundreds of individual steps. Errors in even one of the steps may affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment devices (such as a SEM) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput assessment, some of the assessment apparatuses use multiple focused beams, i.e. a multi-beam, of primary electrons. The component beams of the multi-beam may be referred to as sub-beams or beamlets. A multi-beam can scan different parts of a sample simultaneously. A multi-beam apparatus can therefore assess a sample at a much higher speed than a single-beam apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons. For example, reference to an electron-optical apparatus may be more generally considered to be reference to a charged particle-optical apparatus, with the charged particles not necessarily being electrons.

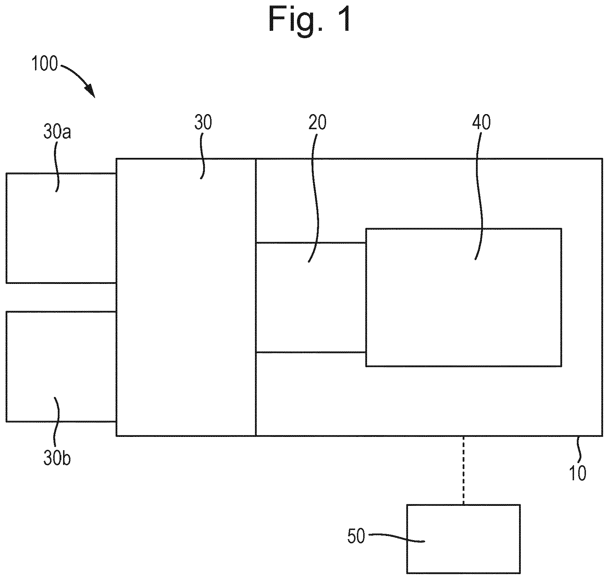

Reference is now made to FIG. 1, which is a schematic diagram illustrating an exemplary electron beam assessment system 100, which may also be referred to as an assessment system. The electron beam assessment system 100 may be an inspection system or a metrology system. The electron beam assessment system 100 of FIG. 1 includes a main chamber 10, a load lock chamber 20, an electron-optical apparatus 40, an equipment front end module (EFEM) 30 and a controller 50. The electron-optical apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron-optical apparatus 40 may comprise a multi-beam electron-optical apparatus.

The controller 50 is electronically connected to electron-optical apparatus 40. The controller 50 may be a processor (such as a computer) configured to control the electron beam assessment apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the electron beam assessment apparatus 100 or it can be distributed over at least two of the component elements. While the present disclosure provides examples of the main chamber 10 housing an electron-optical apparatus 40, it should be noted that aspects of the disclosure in their broadest sense are not limited to a chamber housing an electron-optical apparatus. Rather, it is appreciated that the foregoing principles may also be applied to other devices, and other arrangements, that operate under the second pressure.

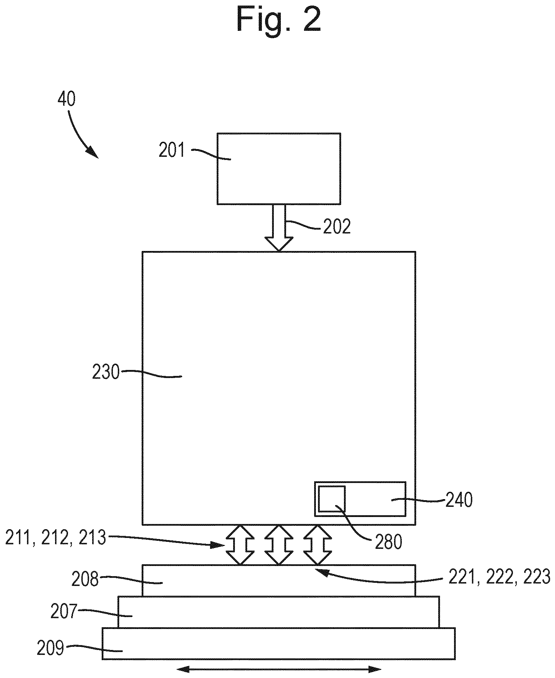

Reference is now made to FIG. 2, which is a schematic diagram illustrating an exemplary electron-optical apparatus 40 that is part of the exemplary electron beam assessment apparatus 100 of FIG. 1. The electron-optical apparatus 40 comprises a source 201 and an electron-optical device 230 (which may be referred to as a column). The electron-optical device 230 may be separate from the source 201 as shown in FIG. 2. Alternatively the electron-optical device 230 may comprise the source 201. The electron-optical apparatus 40 further comprises actuatable stage 209 (which may be referred to as a motorized stage or a stage) and a sample holder 207. The sample holder 207 is supported by the stage 209 so as to hold a sample 208 (e.g., a substrate or a mask) for assessment. The electron-optical apparatus 40 further comprises a detector array 240 (e.g. an electron detection device). The electron-optical device 230 may comprise the detector array 240.

The source 201 may comprise a cathode (not shown) and an extractor or anode (not shown). During operation, the source 201 is configured to emit electrons as primary electrons from the cathode. The primary electrons are extracted or accelerated by the extractor and/or the anode to form a source beam 202.

The electron-optical device 230 is configured to convert the source beam 202 into a plurality of primary beams 211, 212, 213 and to direct each primary beam onto the sample 208. Although three primary beams are illustrated for simplicity, there may be many tens, many hundreds, many thousands, many tens of thousands or many hundreds of thousands of primary beams. The primary beams may be referred to as sub-beams or beamlets.

The controller 50 may be connected to various parts of the electron beam assessment apparatus 100 of FIG. 1, such as the source 201, the detector array 240, the electron-optical device 230, and the stage 209. The controller 50 may perform various image and signal processing functions. The controller 50 may also generate various control signals to govern operations of the electron beam assessment apparatus 100, including the electron-optical apparatus 40.

The electron-optical device 230 may be configured to focus primary beams 211, 212, and 213 onto a sample 208 for assessment and may form three probe spots 221, 222, and 223 on the sample surface of the sample 208. The electron-optical device 230 may be configured to deflect the primary beams 211, 212, and 213 to scan the probe spots 221, 222, and 223 across beam areas in a region of the sample surface of the sample 208. In response to incidence of the primary beams 211, 212, and 213 on the probe spots 221, 222, and 223 on the sample 208, electrons are generated from the sample 208 which include secondary electrons and backscattered electrons which may be referred to as signal electrons. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary beams 211, 212, and 213. As electrons detected with an energy of less than 50 eV is generally treated as a secondary electron, a proportion of the actual backscattered electrons will be counted as secondary electrons.

The detector array 240 is configured to detect signal electrons such as secondary electrons and/or backscattered electrons and to generate corresponding signals which are sent to a signal processing system 280, e.g. to construct images of the corresponding scanned areas of sample 208. The detector array 240 may be incorporated into the electron-optical device 230.

The signal processing system 280 may comprise a circuit (not shown) configured to process signals from the detector array 240 so as to form an image. The signal processing system 280 could otherwise be referred to as an image processing system. The signal processing system may be incorporated into a component of the electron-optical apparatus 40 such as the detector array 240 (as shown in FIG. 2). However, the signal processing system 280 may be incorporated into any number of components of the electron beam assessment apparatus 100 or electron-optical apparatus 40, such as, as part of the electron-optical device 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample. The above functions of the signal processing system 280 may be carried out in the controller 50 or shared between the signal processing systems 280 and controller 50 as convenient.

The controller 50 may control the stage 209 to move sample 208 during assessment of the sample 208. The controller 50 may enable the stage 209 to move the sample 208 in one or more selected directions, continuously or discontinuously. In some arrangements, the movement may be performed at a constant speed. The movement of the sample 208 may be referred to as scanning. This scanning may therefore be continuous or discontinuous. The controller 50 may control movement of the stage 209 so that it changes the speed of the movement of the sample 208 dependent on various parameters. For example, the controller 50 may control the stage speed (and/or direction) depending on the characteristics of the assessment steps of scanning process and/or scans of the scanning process for example as disclosed in WO2022128392 published on 23 June 2022 which is hereby incorporated in so far as the combined stepping and scanning strategy at least of the stage.

Known multi-beam systems, such as the electron-optical apparatus 40 and electron beam assessment apparatus 100 described above, are disclosed in US2020118784, US20200203116, US 2019/0259570 and US2019/0259564 which are hereby incorporated by reference.

The electron-optical apparatus 40 may comprise a projection assembly to regulate accumulated charges on the sample by illuminating the sample 208.

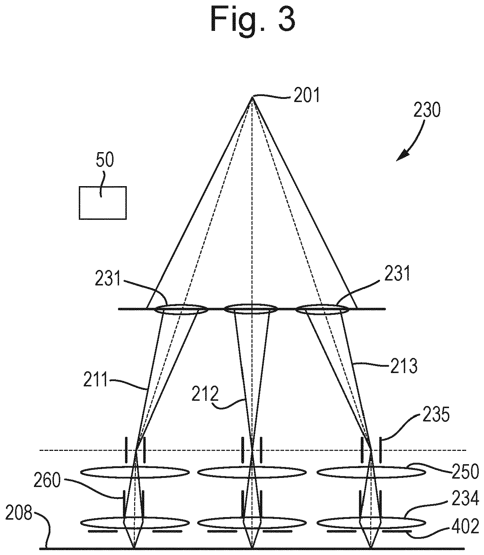

FIG. 3 is a schematic diagram of an exemplary electron-optical device 230 for use in an electron-optical apparatus 40. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. It will be understood however that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along beam paths of primary beams of a beam grid.

The source 201 directs electrons toward an array of condenser lenses 231 (otherwise referred to as a condenser lens array). The source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split a beam such as a source beam into a plurality primary beams, with the array providing a lens for each primary beam. The array of condenser lenses 231 may take the form of at least two plates, preferably three, acting as electrodes, with an aperture in each plate aligned with each other and corresponding to the location of a sub-beam. At least two of the plates are maintained during operation at different potentials to achieve the desired lensing effect. Between the plates of the condenser lens array are electrically insulating plates for example made of an insulating material such as ceramic or glass, with one or more apertures for the sub-beams. An alternative arrangement one more of the plates may feature apertures each with their own electrode, each with an array of electrodes around their perimeter or arranged in groups of apertures having a common electrode.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective primary beam 211, 212, 213 which is focused at a respective intermediate focus 233. A collimator or an array of collimators 235 may be positioned to operate on the respective intermediate focus 233. The collimators 235 may take the form of an electron-optical element such as an array of deflectors or a collimating lens array provided at the intermediate focuses 233, for example as disclosed in EPA 23211553.5 filed on 22 November 2023, the disclosure therein of such a collimating lens array being hereby incorporated by reference. The collimators 235 are configured to bend a respective primary beam 211, 212, 213 by an amount effective to ensure that the principal ray (which may also be referred to as the beam axis) is incident on the sample 208 substantially normally (i.e. at substantially 90° to the nominal surface of the sample).

Below (i.e. downbeam of or further from source 201) collimators 235 there is a control lens array 250 comprising a control lens 251 for each primary beam 211, 212, 213. Control lens array 250 may comprise two or more, preferably at least three, plate electrode arrays connected to respective potential sources, preferably with insulating plates in contact with the electrodes for example between the electrodes. Each of the plate electrode arrays may be referred to as a control electrode. A function of control lens array 250 is to optimize the beam opening angle with respect to the demagnification of the beam and/or to control the beam energy delivered to the objective lenses 234, each of which directs a respective primary beam 211, 212, 213 onto the sample 208.

Optionally an array of scan deflectors 260 is provided between the control lens array 250 and the array of objective lenses 234 (objective lens array). The array of scan deflectors 260 comprises a scan deflector 260 for each primary beam 211, 212, 213. Each scan deflector is configured to deflect a respective primary beam 211, 212, 213 in one or two directions so as to scan the primary beam across the sample 208 in one or two directions.

A detector array 240 is provided within or between the objective lenses 234 and the sample 208 to detect signal electrons/ particles emitted from the sample 208. An exemplary construction of such a detector array 240 is described below. Note that additionally or alternatively the electron-optical apparatus 40 may comprise detector elements upbeam along the primary beam path of the objective lens array or even the control lens array.

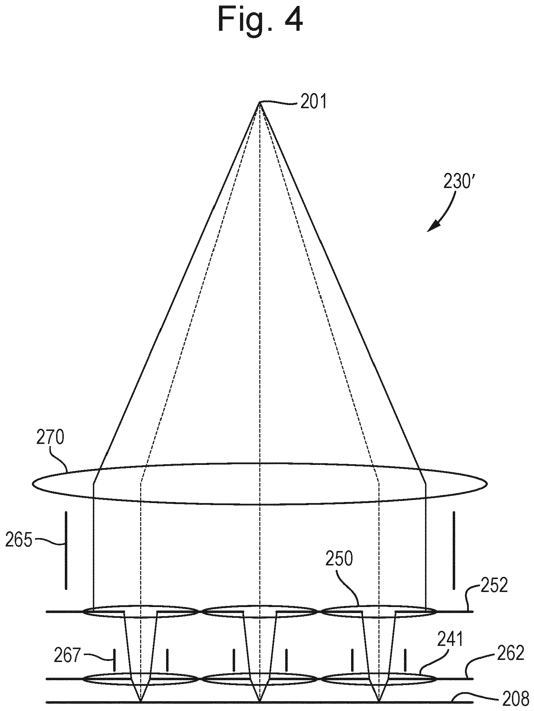

FIG. 4 is a schematic diagram of an exemplary electron-optical device 230. The electron-optical device 230 comprises an objective lens array 241. The objective lens array 241 comprises a plurality of objective lenses. The objective lens array 241 may be an exchangeable module. For conciseness, features of the electron-optical device 230 that have already been described above may not be repeated here.

As shown in FIG. 4, the electron-optical apparatus 40 comprises a source 201. The source 201 provides a beam of electrons. The beam grid of primary beams focused on the sample 208 is derived from the source beam provided by the source 201. Primary beams may be derived from the source beam, for example, using a beam limiter defining an array of beam-limiting apertures. The source beam may separate into the primary beams on meeting the control lens array 250. The primary beams are substantially parallel on entry to the control lens array 250. The primary beams may be arranged in a beam grid which may be referred to as a multi-beam or a multi-beam arrangement. The beam grid may be hexagonal, rectilinear, rhombic or square. In the example shown, a collimator is provided upbeam of the objective lens array assembly.

The collimator may comprise a macro collimator 270. The macro collimator 270 acts on the source beam from the source 201 before the source beam has been split into the beam grid. The macro collimator 270 bends respective portions of the source beam by an amount effective to ensure that a beam axis of each of the primary beams derived from the source beam is incident on the sample 208 substantially normally (i.e. at substantially 90° to the nominal surface of the sample 208). The macro collimator 270 comprise a magnetic lens and/or an electrostatic lens. In another arrangement (not shown), the macro collimator may be partially or wholly replaced by a collimator element array provided downbeam of the upper beam limiter.

In the electron-optical device 230 of FIG. 4 a macro scan deflector 265 is provided to cause primary beams to be scanned over the sample 208. The macro scan deflector 265 deflects respective portions of the beam grid to cause the primary beams to be scanned over the sample 208. In an embodiment, the macro scan deflector 265 comprises a macroscopic multipole deflector, for example with eight poles or more. The deflection is such as to cause primary beams derived from the source beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250. In another arrangement (not shown), the macro scan deflector 265 may be partially or wholly replaced by a scan deflector array, for example as a scan deflector 267 for each primary beam. In other embodiments both a macro scan deflector 265 and the scan deflector array are provided, and they may operate in synchronization.

In some embodiments, the electron-optical device 230 further comprises an upper beam limiter 252. The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms primary beams from a source beam of electrons emitted by the source 201. Portions of the source beam other than those contributing to forming the primary beams may be blocked (e.g. absorbed) by the upper beam limiter 252 so as not to interfere with the primary beams downbeam. The upper beam limiter 252 may be referred to as a primary beam defining aperture array.

In some embodiments, as exemplified in FIG. 4, the objective lens array assembly (which is a unit that comprises the objective lens array 241) further comprises a beam shaping limiter 262. The beam shaping limiter 262 defines an array of beam-limiting apertures. The beam shaping limiter 262 may be referred to as a lower beam limiter, lower beam-limiting aperture array or final beam-limiting aperture array. The beam shaping limiter 262 may comprise a plate (which may be a plate-like body) having a plurality of apertures. The beam shaping limiter 262 may be downbeam from at least one electrode (optionally from all electrodes) of the control lens array 250. In some embodiments, the beam shaping limiter 262 is downbeam from at least one electrode (optionally from all electrodes) of the objective lens array 241. In an arrangement, the beam shaping limiter 262 is structurally integrated with an electrode of the objective lens array 241. Desirably, the beam shaping limiter 262 is positioned in a region of low electrostatic field strength. The alignment of the beam limiting apertures with the objective lens array is such that a portion of a primary beam from the corresponding objective lens can pass through the beam-limiting aperture and impinge onto the sample 208, so that only a selected portion of the primary beam incident onto the beam shaping limiter 262 passes through the beam-limiting aperture.

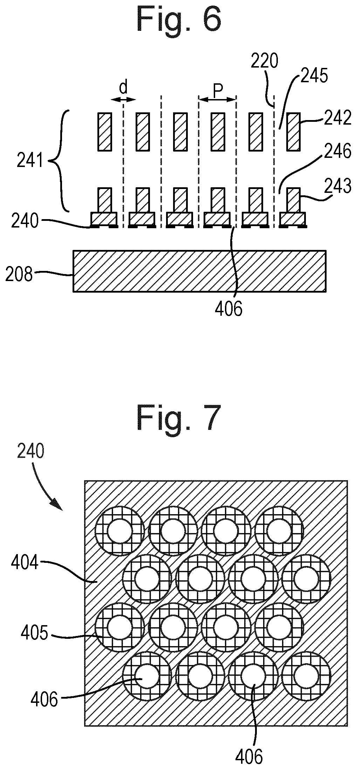

Any of the objective lens array assemblies described herein may further comprise a detector array 240. The detector array detects electrons emitted from the sample 208. The detected electrons may include any of the electrons detected by an SEM, including signal electrons such as secondary and/or backscattered electrons emitted from the sample 208. An exemplary construction of a detector array 240 is described in more detail below with reference to FIGs. 6 and 7.

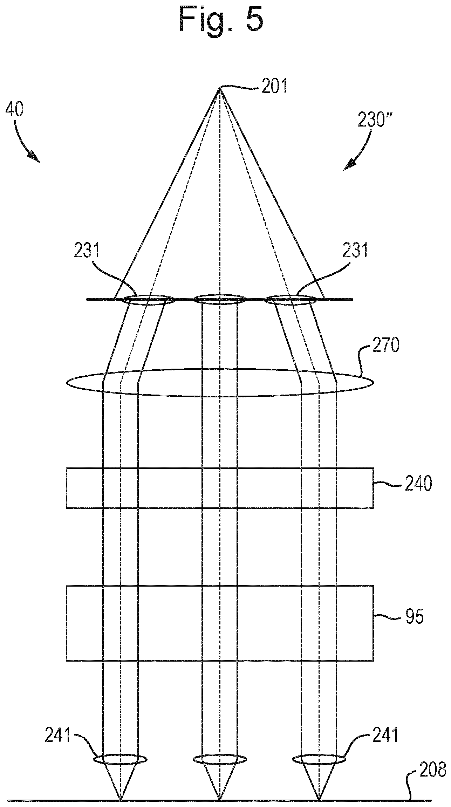

FIG. 5 schematically depicts an electron-optical apparatus 40 including an electron-optical device 230 according to an embodiment. Features that are the same as those described above are given the same reference numerals. For conciseness, such features are not described in detail with reference to FIG. 5. For example, the source 201, the condenser lenses 231, the macro collimator 270, the objective lens array 241 and the sample 208 may be as described above.

As described above, in an embodiment the detector array 240 is between the objective lens array 241 and the sample 208. The detector array 240 may face the sample 208. Alternatively, as shown in FIG. 5, in an embodiment the objective lens array 241, which comprises the plurality of objective lenses, is between the detector array 240 and the sample 208.

In an embodiment a deflector array 95 is between the detector array 240 and the objective lens array 241. In an embodiment the deflector array 95 comprises a Wien filter array so that deflector array may be referred to as a beam separator. The deflector array 95 is configured to provide a magnetic field to disentangle the charged particles projected to the sample 208 apart from the secondary electrons from the sample 208 towards the detector array 240. The deflector array 95 may function as a scanning deflector. Such a scanning deflector may scan the sub-beams relative to the sample surface during assessment of the sample 208.

In an embodiment the detector array 240 is configured to detect signal particles by reference to the energy of the charged particle, i.e. dependent on a band gap. Such a detector array 240 may be called an indirect current detector. The secondary electrons emitted from the sample 208 gain energy from the fields between the electrodes. The secondary electrons have sufficient energy once they reach the detector array 240. In a different arrangement the detector array 240 may be a scintillator array for example of fluorescing strip between the beams and that are positioned upbeam along the primary beam path with respect to the Wien filter. Primary beams passing through the Wien filter array (e.g. of magnetic and electrostatic strips orthogonal to the primary beam path) have paths upbeam and downbeam of the Wien filter array that are substantially parallel, whereas signal electrons from the sample are directed by the Wien filter array towards the scintillator array. The generated photons are directed via a photon transport unit (e.g. an array of optical fibers) to a remote optical detector which generates a detection signal on detection of a photon. Other types of detector may be used in place or in addition to such a scintillating arrangement detector.

The objective lens array 241 of any embodiment may comprise at least two electrodes in which are defined aperture arrays. In other words, the objective lens array comprises at least two electrodes with a plurality of holes or apertures. FIG. 6 shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same primary beam or group of primary beams in the beam grid. In other words, corresponding apertures in the at least two electrodes are aligned with and arranged along a primary beam path. Thus, the electrodes are each provided with apertures through which the respective primary beam 211, 212, 213 propagates.

The objective lens array 241 may comprise two electrodes, as shown in FIG. 6, or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens (for example with at least three electrodes) is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the primary beam paths. The distance between adjacent electrodes, in which an insulating structure might be positioned as described below, is larger than an objective lens of the objective lens array.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

A detector array 240 is provided to detect signal particles, i.e. secondary and/or backscattered charged particles, emitted from the sample 208. The detector array 240 is positioned between the objective lenses 234 and the sample 208. On direction of a signal particle the detector generates a detection signal. The detector array 240 may otherwise be referred to as a detector array or a sensor array, and the terms "detector" and "sensor" are used interchangeably throughout the application.

The electron-optical device 230 is configured to direct (e.g. project) primary beams of electrons towards the sample 208. The electron-optical device 230 may comprise the objective lens array 241. The electron-optical device 230 may comprise the detector array 240. The array of objective lenses (i.e. the objective lens array 241) may correspond with the detector array 240 and/or any of the primary beams.

An exemplary detector array 240 is described below. The detector array 240 may comprise detector elements 405 (e.g. sensor elements such as capture electrodes). The detector array 240 may comprise any appropriate type of detector element. For example, capture electrodes for example to detect directly electron charge, scintillators or PIN elements can be used. The detector array 240 may be a direct current detector or an indirect current detector. The detector array 240 may be a detector array as described below in relation to FIG. 7.

The detector array 240 may be positioned between the objective lens array 241 and the sample 208. The detector array 240 is configured to be proximate the sample 208. The detector array 240 may be very close to the sample 208. Alternatively, there may be a larger gap from the detector array 240 to the sample 208. The detector array 240 may be positioned in the device so as to face the sample 208. Alternatively, the detector array 240 may be positioned elsewhere in the electron-optical apparatus 40 such that part of the electron-optical device 230 that is not a detector array faces the sample 208.

FIG. 7 is a bottom view of the detector array 240 which comprises a detector substrate 404 on which are provided a plurality of detector elements 405 each surrounding a beam aperture 406. The beam apertures 406 may be formed by etching through the detector substrate 404. In the arrangement shown in FIG. 7, the beam apertures 406 are in a hexagonal close packed array. The beam apertures 406 can also be differently arranged, e.g. in a rectangular, or a rhombic, array. The beam arrangement of the hexagonal arrangement in FIG. 7 may be more densely packed than a square beam arrangement. The detector elements 405 may be arranged in a rectangular array or a hexagonal array. The beam apertures may correspond to the beam grid of the primary beams towards the sample 208.

Capture electrodes 405 form the bottommost, i.e. most close to the sample, surface of the detector array 240. Between the capture electrodes 405 and the main body of the detector substrate 404 a logic layer is provided. Logic layer may include amplifiers, e.g. Trans Impedance Amplifiers, analogue to digital converters, and readout logic. In an embodiment, there is one amplifier and one analogue to digital converter per detector element 405. A circuit featuring these elements may be comprised in a unit area referred to as a cell that is associated with an aperture. The detector array 240 may have several cells each associated with an aperture. Within or on the substrate is a wiring layer connected to the logic layer and externally connecting the logic layer of each cell for example via power, control and data lines. The integrated detector array 240 described above is particularly advantageous when used with a system having tunable landing energy as secondary electron capture can be optimized for a range of landing energies. A detector array can also be integrated into other electrode arrays, not only the lowest electrode array. Such a detector array may feature detector elements that are scintillators or semiconductor detectors such as PIN detectors, for example above the downbeam most surface of the objective lens. Such detector arrays may feature a similar circuit architecture as a detector array comprising a current detector. Further details and alternative arrangements of a detector array integrated into an objective lens can be found in US2021210309A1 and US2023238211A1, both of which documents are hereby incorporated by reference at least so far as details of the detector array.

The detector elements 405 may be associated with respective primary beams 211, 212, 213. Thus, the detector elements 405 of the detector array 240 may be configured to detect signal electrons emitted from the sample 208 in relation to one of the primary beams 211, 212, 213. In other words, the detector elements 405 may be associated respective apertures in at least one of the electrodes of the objective lens assembly. More specifically, the detector elements 405 may be arranged around respective apertures 406. As mentioned the detection signal from the detector array is used to generate an image. With multiple detecting portions, the detection signal comprises components from the different detecting signals that may be processed as data sets or in a detection image.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the system and can be swapped between operable and non-operable positions without opening the electron-optical apparatus 40.

In some embodiments, one or more aberration correctors are provided that reduce one or more aberrations in the primary beams. Aberration correctors positioned in, or directly adjacent to, the intermediate foci (or intermediate image plane) may comprise deflectors to correct for the source 201 appearing to be at different positions for different beams. Correctors can be used to correct macroscopic aberrations resulting from the source that prevent a good alignment between each sub-beam and a corresponding objective lens. Aberration correctors may correct aberrations that prevent a proper column alignment. Aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. Aberration correctors may reduce one or more of the following: field curvature; focus error; and astigmatism.

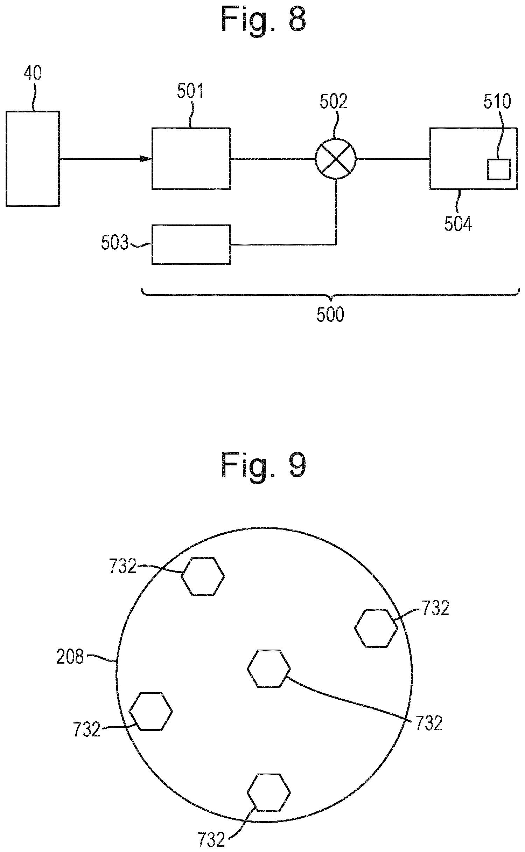

Images (which may be represented by image data sets) output from the electron-optical apparatus 40, may be processed automatically to detect defects in samples 208 being assessed. An image data set (which may be referred to as an image) may comprise data points. The data points may be referred to as pixels. A region of pixels is an image which may be referred to as a clip. The region of pixels may surround a pixel or group of pixels identified as a potential defect. An example data processing device 500 for detecting defects in images generated by a charged particle assessment system is depicted in FIG. 8. Data processing device 500 may be part of controller 50, part of another computer in the fab or integrated elsewhere in the charged particle assessment device. It should be noted that the arrangement of components of the data processing device 500 as shown and described with reference to FIG. 8 is exemplary and is provided to aid explanation of the functions of data processors that operate on the images generated by the electron beam assessment system 100. Any feasible arrangement conceivable by a person skilled in the art of data processors that is able to achieve the functions of the data processing device 500 as described herein may be used.

In some embodiments, the data processing device 500 comprises a filter module 501 which receives and filters a sample image from an electron-optical apparatus 40, a reference image generator 503 which generates a reference image based on source images, a comparator 502 which compares the filtered sample image to the reference image and an output module 504 which processes and outputs the result of the comparison.

Filter module 501 applies a filter, e.g. a uniform filter, of predetermined size to the sample image. Applying a uniform filter comprises convoluting the sample image with a uniform kernel. The size of the uniform kernel is determined, e.g. by the user, for inspection of a given sample based on, for example, the size of features on the sample, the size of defects to be detected, the resolution of the electron beam assessment system 100, the amount of noise in the images and the desired compromise between sensitivity and selectivity. Deviation from a mathematically uniform filter is permissible. For example corner filters could have values that would slightly overweight those pixels but not significantly. Non-uniform filters, e.g. a Gaussian filter, may be conveniently implemented by convolution with a suitable kernel. Filter module 501, especially when configured to apply a uniform filter of predetermined size, is conveniently implemented by dedicated hardware, e.g. an FPGA or an ASIC.

The reference image generator 503 may be operable in one or more modes, each mode representing a different approach to generation of the reference image.

In a library mode, the reference image generator 503 averages a large number of source images obtained from previous scans of patterns nominally the same as the pattern currently being assessed. Such images may have been generated earlier in the same batch of samples, or from samples in previous batches. The library images may be derived from test samples or production samples. Before averaging, the images are desirably aligned with one another. Averaging the source images to generate the reference image has the effect of reducing noise. Averaging the source images in this way also averages away any defects that might be visible in the source images. In an embodiment a reference image is derived from an image file of the intended pattern rather than data obtained from scanning a sample. A scan from a sample may be compared to such a reference image. This may be referred to as a die-to-database mode.

In the case where the pattern being inspected is a repeating pattern, it is possible to generate the reference image by averaging a plurality of shifted versions of a source image. If either or both dimensions of the unit cell are not equal to an integer number of pixels, the shift amount can be rounded to the nearest pixel or a fractional pixel shift can be effected by interpolation, for example linear or cubic interpolation, such as bicubic interpolation, or any other known interpolation technique. Another possibility is to shift by a multiple of the pitch of the repeating pattern such that the multiple is an integer number of pixels. In effect, multiple instances of the unit cell are extracted from the source image and averaged. This approach may be referred to as an example of an array mode, more specifically of providing a reference image for an array mode.

In a die-to-die mode, three electron-optical devices 230 of an apparatus comprising a plurality of electron-optical devices 230 may be used to generate a sample image and two reference images. An image aligner is provided to align the images before they are supplied to the reference image generator 503 and filter module 501 as appropriate. This arrangement is particularly efficient where the spacing between electron-optical devices 230 is equal to the die size of the sample being inspected since the electron-optical devices 230 will then automatically scan corresponding pattern features simultaneously. In a case where there is a difference between the electron-optical device spacing and die size, a buffer may be employed to correct the timing of images input to the data processing device.

In an alternative variant of die-to-die mode, the same beam (of the same electron-optical devices in the case of an apparatus comprising a plurality of electron-optical devices) is used to generate a sample image and two reference images. This has the advantage that the electron-optical device to electron-optical device and beam to beam corrections (e.g., correction of the relative position of a beam relative to the ideal beam position for that beam or even for each beam) are not required and the routing of data can be simplified. Using the same beam avoids the calibration, e.g. assessment of the offset, between beams for the different scans that are compared. Using the same beam means that although the beam may have an offset with respect to the ideal beam position, there is no positional offset to correct for when comparing data retrieved from the scans. However, the need for data buffering might be increased, for example in frequency, if not in quantity of data buffered before the start of the comparison of the data from different dies.

It should be noted that it is also possible to apply the uniform filter to the source images and/or the reference images, in particular where the reference image is derived from a small number of source images that are obtained concurrently with the source image.

With reference again to FIG. 8, comparator 502 may be any logic circuit capable of comparing two values, for example an XOR gate or a subtractor. Comparator 502 is also suitable for implementation by dedicated hardware, e.g. an FPGA or an ASIC. Desirably, comparator 502 is implemented on the same dedicated hardware as filter module 501.

In some cases, the reference image generator 503 can also be implemented in dedicated hardware, especially where the reference image generator operates only in a mode where the reference image is generated from a small number of, e.g. two, source images. In that case it is desirable that the reference image generator is implemented in the same dedicated hardware as the comparator and/or filter module. The mathematical operations to average pixels of source images and compare to a pixel of a sample image can, in suitable cases, be combined into a single logic circuit.

Output module 504 receives the results output by comparator 502 and prepares output to the user or other fab systems. The output may be in any of several different forms. In a simplest option, the output may simply be an indication that the sample has or does not have a defect. However, since almost all samples will have at least one potential defect more detailed information is desirable. The output may comprise, for example, a map of defect locations, a difference image, and/or information as to the severity of a possible defect represented by the magnitude of the difference between the sample image and the reference image. Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information as a data set may be used, e.g. a list or a map. Desirably, output module 504 may output clips. A clip is an image of a portion of the sample surface, or a region of pixels representative of potential defects. This allows the potential defect to be further examined to determine if clip is representative of a defect. That is that the defect is not actually a nuisance signal. Processing of the clip may determine if the defect is sufficiently significant to affect operation of the device structure which either is or could be formed on or present in the sample. The rest of the source image, i.e. those parts not saved as clips, may be discarded so as to avoid to conserve data storage and data transfer requirements.

FIG. 9 schematically depicts regions 732 of a sample surface of a sample 208. In an embodiment the electron-optical device 230 is configured to direct the beam grid of primary beams of electrons toward a region 732 of a sample surface of the sample 208. A plurality of the regions 732 may correspond to respective dies, for example so different regions may cover a portion of different dies. A plurality of the regions 732 may correspond to the same die. A region 732 may correspond to a plurality of dies.

In an embodiment the electron-optical apparatus 40 is configured to process one or more of the regions 732. The electron-optical apparatus 40 may process a region 732 with the primary beams of the beam grid. Processing may comprise directing a primary beam onto the sample surface.

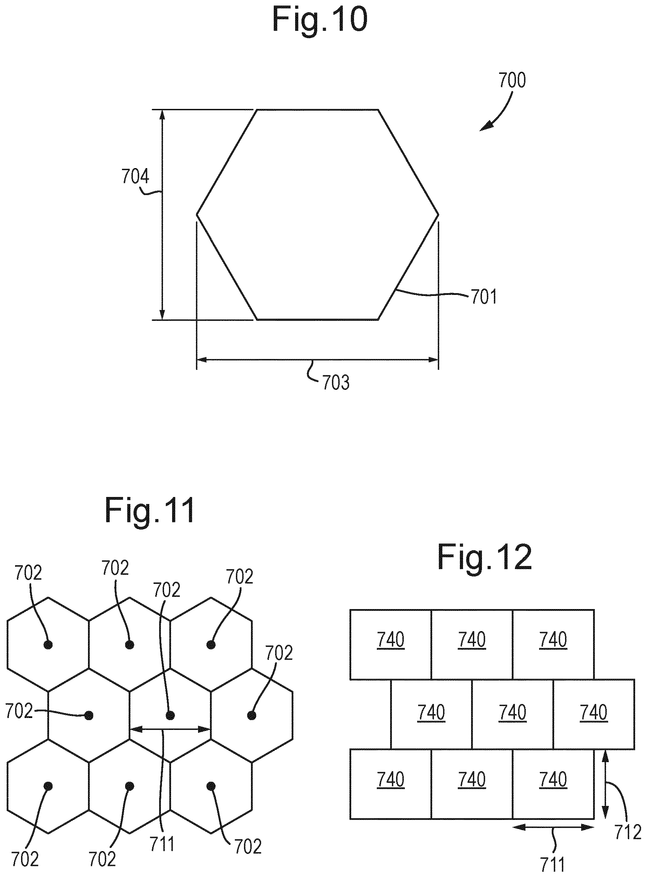

FIG. 10 schematically depicts a beam grid 700 of primary beams (which may be referred to as beams 701). As shown in FIG. 10, in an embodiment the beam grid 700 comprises a hexagonal grid. Alternatively, the beam grid 700 may be of any shape for example square, rectangular or circular, for example.

As shown in FIG. 10, in an embodiment the beam grid 700 comprises a plurality of rings of beams 701. The rings of beams 701 may be substantially concentric. As shown in FIG. 10, in an embodiment the beam grid 700 has a major dimension 703 and a minor dimension 704. The major dimension 703 is greater than the minor dimension 704. In an embodiment the dimensions of the beam grid 700, for example at a position along the beam path proximate to the sample surface such as when the beams of the beam grid are collimated, are similar to the dimensions of the regions 732 on the sample surface of the sample 208.

FIG. 11 and 12 depict an example relationship between a geometry of a beam grid of primary beams (defined by grid positions 702 of the primary beams) and a geometry of beam areas 740. A pitch 711 of the beams of the beam grid may correspond to a distance between corresponding points (e.g. center or edge) of adjacent beams or relative to adjacent beams. Each beam area 740 may have a similar shape. The shape of a beam area 740 may typically be rectangular or square. The array may have other forms, such as parallelogram or rhombus. Together, the beam areas 740 are scanned by different primary beams and thus define a discontinuously scanned region of the surface of the sample 208. A region of the sample surface of the sample 208 may be considered to be a discontinuously scanned part of the sample surface of the sample 208.

The example of FIG. 11 and 12 demonstrates that the symmetry of the beam grid does not need to be the same as the symmetry of the beam areas 740. In the example shown, the primary beams are provided on a hexagonal grid (i.e., a grid having hexagonal symmetry), while the beam areas 740 are rectangular.

In a specific example case where the primary beams are provided in a hexagonal array with a pitch. In an embodiment the pitch is at least 10µm, optionally at least 20µm, optionally at least 50µm, optionally at least 100µm, and optionally at least 200µm. In an embodiment the pitch is at most 500µm, optionally at most 200µm, optionally at most 100µm, optionally at most 50µm, and optionally at most 20µm. For example, the pitch may be 10µm, 20µm, 70µm, 100µm or 300µm. Each beam 701 may be scanned within a rectangular area (defining the beam area 740) with an aspect ratio in the range of, for example 2: 1 to 1:1. For example, the aspect ratio may be about 5:4, 7:6 or 10:9. In an example case where the field of view of an objective lens (which defines the maximum range of relative movement between the multi-beam and the sample surface that the electron-optical device 230 can provide at a fixed position of the sample 208 relative to the electron-optical device 230) is about 1 micron, to cover one area of 100µm × 90µm would require 90 scans of strips that are 1µm wide. Note: in a different arrangement the primary beams may be provided in an array having a grid of a different shape, for example parallelogram, rhombus, rectangular or square. For each shape of beam arrangement, the beam areas 740 may be rectangular.

In some embodiments, an image rendering is derived from a scan of the sample 208, for example a data set derived from the scan of the sample 208. The image comprises a plurality of beam areas 740 arranged in a grid. Each beam area 740 of a region of a sample surface is scanned by a primary beam of the beam grid. The grid of beam areas 740 may have a dimension corresponding to the pitch 711 of the primary beams of the beam grid.

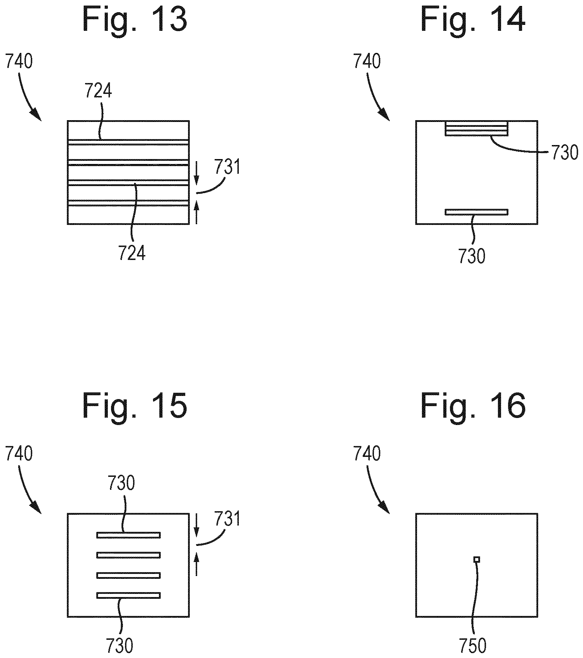

In an embodiment, each beam 701 processes a respective beam area 740. The processing may comprise scanning the primary beam relative to the sample surface. Scanning refers to relative movement between the beam 701 and the sample surface. In an embodiment the controller 50 is configured to control the electron-optical apparatus 40 to selectively apply one of a plurality of predetermined beam area patterns. A beam area pattern indicates which portions of each beam area 740 are to be processed with a primary beam of the beam grid 700. FIGs. 13-20 schematically depict different possible beam area patterns. All the beams may have substantially the same beam area pattern. Scanning can be done by mechanically scanning the sample 208 or by deflecting the beams by a deflector. The deflector may be configured to apply substantially the same deflection for each of the beams. For example, the deflector may be a macroscopic deflector.

In an embodiment the controller 50 is configured to control the electron-optical apparatus 40 to process portions of respective beam areas 740 of the region 732 with respective beams 701 in accordance with the applied beam area pattern. For example, FIG. 13 schematically depicts a beam area pattern comprising a plurality of elongate strips 724. The elongate strips 724 are distanced from each other. For example, a gap 732 may be provided between adjacent elongate strips 724. The gaps between the elongate strips 724 in the pattern may correspond at least in dimension to a width of elongate strips of one or more elongate strips. The elongate strips have an elongate direction that may be in the direction of a length of the beam area 740. When the electron-optical apparatus 40 applies the beam area pattern shown in FIG. 15, then the electron-optical apparatus 40 processes portions of respective beam areas 740 corresponding to the elongate strips 724.

In an embodiment, corresponding portions of the beam areas 740 are processed. The same beam area pattern is applied for processing each of the beam areas 740. Substantially all of the beams 701 of the beam grid 700 may be scanned across their respective beam areas 740 in the same way, for example simultaneously.

In an embodiment the beam area patterns are associated with respective portions of the beam areas 740 being processed. For example, FIG. 15 schematically shows a beam area pattern comprising shortened elongate strips 730. The shortened elongate strips 730 of the beam area pattern shown in FIG. 15 are shorter than the elongate strips 724 of the beam area pattern shown in FIG. 13. The dimension of the elongate strips 730 in a direction of elongation may be shorter than dimension of the beam area in the same direction of elongation of the elongate strips 730. As per the pattern shown in and described with reference to FIG. 13, the gaps between adjoining elongate strips in the pattern may correspond at least in dimension to a width of one or more of the elongate strips. The beam area pattern of FIG. 15 may be associated with a smaller proportion (compared to the beam area pattern of FIG. 13) of the beam area 740 being processed. In an embodiment the beam area pattern that is selected to be applied may be selected based at least partly on the associated proportion of the beam area 740 to be processed.

In general, a smaller proportion of the beam area 740 being processed may correspond to less time being required to process the beam area 740 for example for a use case in which representative data (e.g. images) of a beam area is sufficient. Less data may provide representative statistics. An embodiment of the invention is expected to reduce the time required to process a beam area 740. For example, in a use case the scanning time (or more generally the time to acquire sample data such as images) is balanced with quantity of sample data (e.g. size of images of the sample) acquired. Sparser statistics may be collected over a larger area (e.g. the entire sample 208) rather than denser statistics being collected over a smaller area (e.g. one region 732). This may provide a more optimal sampling across a sample 208. An embodiment of the invention is expected to reduce the time required to process a region 732. An embodiment of the invention is expected to increase throughput and/or provide a more optimal sampling across a sample.

In an embodiment, at least one of the beam area patterns (and optionally all of the beam area patterns) is associated with at most 99%, optionally at most 98%, optionally at most 95%, optionally at most 90%, optionally at most 80%, optionally at most 50%, optionally at most 20%, optionally at most 10%, optionally at most 5%, optionally at most 2%, optionally at most 1%, optionally at most 0.5%, optionally at most 0.2%, optionally at most 0.1% and optionally at most 0.05% of the beam area 740 being processed (i.e. scanned).

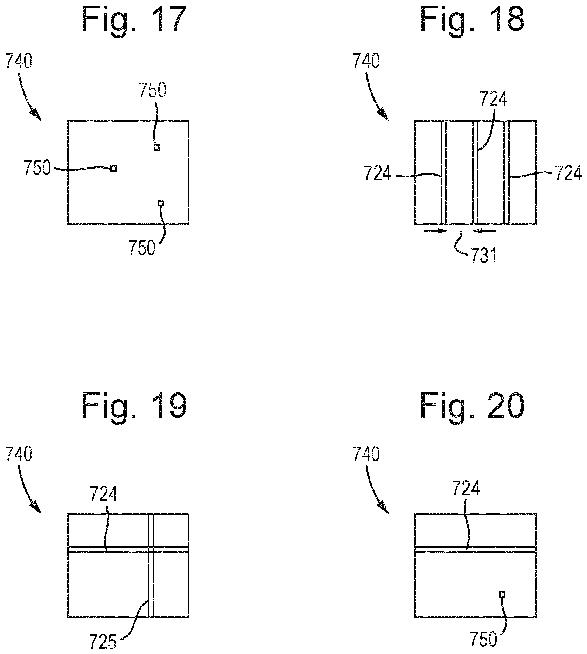

As shown in FIG. 13, for example, in an embodiment at least one of the beam area patterns comprises at least one elongate strip 724. The beam area pattern shown in FIG. 14 also comprises elongate strips, albeit shortened elongate strips 730. Similarly, the beam area patterns shown in FIG. 15, FIG. 18, FIG. 19 and FIG. 20 comprise at least one elongate strip. The beam area patterns shown in FIGs. 13-20 are merely examples of possible beam area patterns. Different beam area patterns are also possible comprising one or more elongate strips. Such different beam area patterns may be a combination of one or more of the beam patterns for example featuring one or more the beam patterns as shown in and described with reference to any of FIGs. 13 to 20. Additionally, the patterns are shown with an elongate direction aligned with the largest dimension of the beam area; however that is not necessarily the case. The elongate strips may be orientated in any direction with respect to the dimensions of a beam area. For example, the elongate direction may be parallel to the largest dimension of the beam area, or may be angled by e.g. 30°, 45°, 60° or 90° to the largest dimension of the beam area. It is not essential for all of the beam area patterns from which the applied beam area pattern may be selected to comprise at least one elongate strip. For example, FIG. 16 and FIG. 17 schematically depict candidate beam area patterns that do not comprise any elongate strip. When a beam area pattern that does not comprise any elongate strip is selected to be applied, one or more other candidate beam area patterns that do comprise at least one elongate strip are not selected.

When a portion (of a beam area 740) corresponding to an elongate strip is processed, the controller 50 may be configured to cause relative movement between the sample support 207 and the electron-optical device 230. Such relative movement may enable the beams 701 and the sample 208 to scan relative to each other. For example, in an embodiment the controller 50 is configured to actuate the stage 209 so as to move the sample 208 relative to the electron-optical device 230. In an alternative embodiment, the controller 50 may be configured to actuate the electron-optical device 230 relative to the sample 208. The relative movement between the electron-optical device 230 and the sample 208 may be referred to as a mechanical scan. The direction of the relative movement may correspond to a slow direction. In an embodiment a dimension of an elongate strip 730 in a direction of the elongate strip 730 corresponds to the relative movement, i.e. the mechanical scan. The mechanical scan is in the direction of elongation of the elongate strip 730.

By mechanically scanning the beam grid 700 relative to the sample 208, a portion corresponding to an elongate strip 724 may be processed without requiring a large electron-optical scanning range. In an arrangement, the electron-optical scanning range may refer to the maximum movement of the beam grid 700 across the sample surface while the electron-optical device 230 has a fixed relative position (i.e. is stationary) relative to the sample 208. By providing for mechanical scanning, the electron-optical device 230 may have greater design freedom. The design of the electron-optical device 230 may be simplified.

In an embodiment the elongate strip 724 has a high aspect ratio. For example, in an embodiment the elongate strip 724 has a length greater than a width by a factor of at least 2, optionally at least 5, optionally at least 10, optionally at least 20, optionally at least 50, optionally at least 100, optionally at least 200 and optionally 500. For example, the elongate strips 724 shown in FIG. 13 may have a length that is about 10-50, for example 100, times their width. The elongate strips 724 shown in FIG. 18 may have a length that is about 10-300, for example 90, times their width. In this arrangement, the elongate direction of the elongate strips may be aligned with a shorter dimension of the beam area 740 for example a breadth of the beam area 740.

In an embodiment, during processing of the beam areas 740 of the region 732, the extent of the mechanical scan may be limited. For example, during processing of a beam area 740, a relative movement between the sample support 207 and the electron-optical device 230 may be at most a dimension of the beam area 740. During processing of a beam area 740, a maximum relative movement between the sample support 207 and the electron-optical device 230 may be at most a dimension of the beam area 740. For example, the beam area 740 may have dimensions of about 100µm by about 90µm. The maximum relative movement between the sample support 207 and the electron-optical device 230 may be at most in a dimension of the beam area of about 10-500µm, for example 100µm or, in a first direction of dimension of the beam area, may be in the range of 10-500µm, for example 100µm in one direction and 10-300µm, for example 90µm in a different direction, for example a second direction, orthogonal to the first direction. In an arrangement in which the elongate direction of the elongate strips are in a different direction from the dimensions of the beam area, the maximum relative motion may be aligned with a diagonal of a beam area, for example (using the value of the exemplary range) of 60 to 140 micron, for example 110 micron. For example, scanning may be performed in one specific direction without rotation of the sample 208.

As shown in FIG. 13, FIG. 15 and FIG. 18, for example, in an embodiment a plurality of elongate strips 724, 730 are distanced from each other. There may be one or more gaps 731 between adjacent elongate strips. In an embodiment the gaps 731 are at least half the width of the elongate strips, and optionally at least the width of the elongate strips, for example two times the width of the elongate strips, five times or 10 times the width of the elongate strips. By increasing the size of the gaps 731, the time taken to process the portions of the beam area 740 in accordance with the beam area pattern may be reduced.

However, it is not essential for the elongate strips to be distanced from each other. As shown in FIG. 14, in an embodiment the priority of elongate strips adjoin each other. As shown in FIG. 14, shortened elongate strips 730 may have a length that is less than the full length of the beam area 740. The processed portions of each beam area 740 do not cover the whole of the beam area 740. The beam area 740 is only partially processed. By only partially processing the beam area 740, it may take less time to process the beam area 740, for example to acquire sufficient data such as from a beam area for an intended use case of assessment. In an embodiment, there may be a small overlap between adjacent shortened elongate strips 730.

In an embodiment the elongate strips have a length at most equal to a pitch 711 of the beams 701 in the beam grid 700. In an embodiment the elongate strips have a length less than a pitch 711 of the beams 701 in the beam grid 700. By reducing the length of the elongate strips, it may be quicker to process the beam areas 740, for example to acquire sufficient data such as from a beam area for an intended use case of assessment. Alternatively, as shown in FIG. 13, in an embodiment the elongate strips 724 may have a length substantially equal to a pitch 711 of the beams 701 in the beam grid 700. The full length of the beam area 740 may be substantially equal to the pitch 711 of the beams 701 in the beam grid 700. Such a pattern for scanning a beam area may be selected to acquire sufficient data such as from a beam area with an acceptable time frame to achieve a throughput that may meet the requirements for an intended use case of assessment.

In an embodiment, one or more of the elongate strips 730 positioned across the corresponding beam area 740 have a combined length at most equal to a pitch 711 of the beams 701 in the beam grid 700. For example, two or three elongate strips 730 may be located along the same line within the beam area 740. The combined length of the two or three strips 730 may be less than or substantially equal to the pitch 711. The strips 730 may be distance from each other along the line. The strips 730 may form (or take the appearance of) a broken (e.g. dashed) line. Such strips 730 that are adjoining may be spaced apart in the elongate direction by an offset.

As shown in FIG. 13, FIG. 14 and FIG. 15, for example, in an embodiment a plurality of the elongate strips 730 have substantially the same length. In an embodiment all of the elongate strips 730 have the same length. However, it is not essential for all of the elongate strips 730 to have the same length. In an alternative embodiment a plurality of the elongate strips 730 have different lengths. For example, FIG. 19 schematically show an embodiment in which different elongate strips 724, 725 have different lengths. In the arrangement shown in and described with reference to FIG. 19, the two depicted elongate strips each have a length corresponding to a different dimension of the beam area. However, that need not be the case. One or more of the elongate strips may have a length shorter than a respective dimension of the beam area.

As shown in FIG. 13, FIG. 14 and FIG. 15, for example, in an embodiment a plurality of the elongate strips 730 have the same orientation across the beam area 740. A plurality of the elongate strips 730 may be substantially parallel to each other. In an embodiment all of the elongate strips 730 are substantially parallel to each other. For example, the elongate strips 730 may be oriented across a width/breadth of the beam area 740. However, it is not essential for all of the elongate strips 730 to have the same orientation. In an alternative embodiment a plurality of the elongate strips 730 have different orientations. For example, FIG. 19 schematically show an embodiment in which different elongate strips 724, 725 have different orientations. In the arrangement shown in and described with reference to FIG. 19, the elongate strips are each a length orientated in a different dimension of the beam area. However, that need not be the case. One or more of the elongate strips may have a length that is orientated in a direction other than a respective dimension of the beam area.

The beam area pattern comprises one or more features. A feature of the beam area pattern may be an elongate strip 730. A feature of the beam area pattern may be a deflection part 750 (described in more detail below). However, features of the beam area pattern are not limited to the shapes of the features shown in the drawings. In an embodiment the beam area pattern of at least one of the beam areas 740 comprises at least one feature having dimensions in different directions of the dimension of a width (or breadth) of the elongate strip 730. In an embodiment the beam area pattern of at least one of the beam areas 740 comprises a plurality of features with dimensions of the width of the elongate strip 730. The features may be distanced from each other. The features may be distributed in the pattern over the beam area.

In an embodiment, the electron-optical apparatus 40 is configured to displace (e.g. step) between different relative positions between the sample 208 and the beam grid 700 for example so that a beam is moved within its beam area. The size of such a displacement (e.g. a step) may be at least as large as the width of the elongate region in a direction across the elongate strip. Desirably a displacement between two features of the pattern may be a multiple of the width of an elongate region. One or more displacements (e.g. steps) may enable processing of a plurality of features of the beam area pattern to be applied. The features may be positioned across a corresponding beam area 740 in a direction of the width of an elongate strip 730. For example, the features may comprise a plurality of elongate strips 730, or the features may comprise one or more of the elongate strips 730 and one or more different features of the beam area pattern.

In an embodiment, the electron-optical apparatus 40 is configured to displace (e.g. step) between the different relative positions such that the beam grid 700 remains within the region (towards which the beams 701 are directed) on the same sample surface. In an embodiment, the different relative positions correspond to respective different features in the beam area pattern. In an embodiment, the controller 50 is configured to control the actuatable stage 209 to displace between the different relative positions between the sample 208 and the beam grid 700. The movement of the beam over the respective beam area may correspond to the beam area pattern.

In general, there is expected to be a correlation between the proportion of the beam area that is processed and the time required to process the beam area 740. In an embodiment, the beam area pattern to be applied may be selected based on the time it takes to process the beam areas 740 in accordance with the beam area pattern.

For example, in an embodiment a target length of time is determined for processing the beam area 740 of a region 732. The beam area pattern may then be selected based on the target time. For example, the beam area pattern may be selected so that the beam area pattern corresponds to the processing of the greatest proportion of the different beam areas 740 of the beam grid. The selected beam area may be such that the processing of the sample region is less than or at most the target time, for example without increasing the time above the target time. Alternatively or additionally, the selection of the beam area pattern to be applied may be based on a target proportion of the area of the beam area 740 to be processed.

In an embodiment the selection of the beam area pattern is based on an expected density of defects. The beam areas 740 may be processed so as to detect defects. That is the data sets may be derived from the scanning of the beam areas of the scanning of the beam grid over a region of the sample. Such data sets (which may be renderable into images) may be used for detecting defects present in the scanned region of the sample. When the expected density of defects, for example over the scanned area of the sample, is high, then a smaller proportion of the beam areas 740 may be selected for processing. Processing smaller portions of the beam area 740 (for example when processing a smaller proportional area of each beam area) for example when the expected density of defects is relatively high, may be expected to allow defects to be identified. The processed area of the sample surface at a relatively high expected density of defects may be sufficient for identify defects within the processed area. When the expected density of defects is relatively low, a greater proportion of the area of each beam area 740 may be processed. By increasing the proportion of the area of each beam area 740 to be processed (or that is processed), the possibility of identifying a defect may be increased. Thus, selected beam area pattern may be based on the expected density of defects for example for a sample under assessment.

The expected density of defects, for example of a sample under assessment, may depend on properties of the sample 208 for example the surface of the sample. For example, it may be that the properties of a portion towards the periphery of the sample 208 are expected to be different from the properties of a portion of the sample closer towards a centre of the sample surface, for example of the sample 208. In an embodiment, the beam area pattern to be applied may be selected based on the position of the region 732 within the sample surface of the sample 208. For example, a beam area pattern corresponding to a higher proportion of an area of the beam area 740 (e.g. to be processed) may be selected for a region 732 closer to the centre of the sample surface or further from a periphery of the sample surface. A beam area pattern for a small proportion of the areas of a beam area 740 (e.g. corresponding to a lower proportion of each beam area 740 being processed) may be selected for a region 732 closer to the periphery of the sample surface or further from the center of the sample surface.

For example, the manufacturing process of structures on the sample 208 may be expected to be more error prone closer to the periphery of the sample 208. For example, in a non-limited list, etching may be less accurate closer to the periphery of the sample surface, and the surface of the sample may have a lower parameter of flatness towards the periphery for example than closer towards a center of the sample surface.

In an embodiment the beam area pattern of the different beam areas 740 of a beam grid 700 are the same. The beam area patterns may be the same. In an embodiment, different beam area patterns are selected for different regions 732. Alternatively, the same beam area pattern may be applied to a plurality of (and optionally all of) the regions 632 of the sample surface of the sample 208. Corresponding portions of the different regions 732 may be processed in different regions 732. This may make it easier to compare the results of the processing of different regions 732 across the sample surface. For example, the same beam area of a beam grid may be scanned by the same beam. Where different regions of the sample correspond to the same port of different dies on the sample surface, the same beam may be used to scan the part of different dies at least different regions covering the same part of the different dies.

In an embodiment a series of different beam area patterns are selected to be applied to respective regions 732 or to respective samples 208. In an embodiment the beam area patterns of the series of beam area patterns cover substantially the whole of a beam area 740 when superimposed on each other. For example, in an embodiment a series of two beam area patterns are selected to be applied to respective regions 732 or to respective samples 208. A first beam area pattern of the series comprises a plurality of elongate strips 724, for example as shown in FIG. 13. The gap 731 between adjacent elongate strips 724 may be substantially equal to the width of each elongate strip 724. The other beam area pattern of the series may comprise a plurality of elongate strips 724 located where the gaps 731 are located in the first of the beam area patterns. In other words, for a beam area that is fully covered by a number of contiguous strips, the beam area pattern applied to a first region 732 or a first sample 208 (or a first beam area pattern) may comprise a set of elongate strips 724 that correspond to every other strip of the contiguous strips. The beam area pattern (or a second beam area pattern) applied to a second region 732 or a second sample 208 has the elongate strips that correspond to the other strips (or the missed strips) of the contiguous strips. Thus, the second region or a region of the second sample may be processed using the second beam pattern.

As a further example, in an embodiment a series of beam area patterns comprises ten beam area patterns. In each beam area pattern, every tenth strip is to be processed. A first beam area pattern may correspond to the first, eleventh, twenty-first, thirty-first etc. strip (out of a plurality of elongate strips that would fully cover the beam area 740). Thus, a beam area scanned using beam area has every tenth elongate strip scanned. The second beam area pattern may correspond to the second, twelfth, twenty-second, thirty-second etc strips. The third beam area pattern may correspond to the third, thirteenth, twenty-third, thirty-third etc strips. The fourth beam area pattern may correspond to the fourth, fourteenth, twenty-fourth, thirty-fourth etc strip. The fifth beam area pattern may correspond to the fifth, fifteenth, twenty-fifth, thirty-fifth strip. The sixth beam area pattern may correspond to the sixth, sixteenth, twenty-sixth, thirty-sixth strips. The seventh beam area pattern may correspond to the seventh, seventeenth, twenty-seventh, thirty-seventh strips. The eighth beam area pattern may correspond to the eighth, eighteenth, twenty-eighth, thirty-eighth strips. The ninth beam area pattern may correspond to the ninth, nineteenth, twenty-ninth, thirty-ninth strips. The tenth beam area pattern may correspond to the tenth, twentieth, thirtieth, fortieth strips. Thus, applying this scanning strategy to a first region 732 may result in processing the beam areas 740 of the first region according to the first beam area pattern. In a second region 732 the beam areas 740 may be processed according to the second beam area pattern. Likewise, a third region 732 is processed applying the third beam area pattern, the fourth region 732 is processed applying the fourth beam area pattern and so on for processing each of the fifth region to the tenth region 732 by applying the respective fifth beam area pattern to the tenth beam area pattern. To process an eleventh region 732 or an eleventh sample 208 the first beam area pattern may be applied.

Thus, the selected beam area pattern may be rotated every tenth region 732 or tenth sample 208. In this example the series is of ten different beam area patterns, however a series of any number of members may be selected. By providing that the beam area patterns of the series would fully cover the beam area 740 when superimposed on each other, it is possible to check whether the processing satisfies one or more properties across the full extent of the mechanical and electron-optical scanning for a given region. However, to minimize scanning time per sample and increase the throughput the effect scanning of the beam area is distributed over multiple regions or even multiple samples. In this example, the full set of member beam area patterns superimpose to cover a contiguous beam area or to provide a combined beam area pattern than covers an entire beam area. However, the combined set of member beam area patterns may superimpose to cover a portion or a part of the beam area pattern, for example which may be determined when balancing the size of the sample area required to be covered, the likely defect density for example of the sample surface processed and the available time for processing (or required throughput).

In an embodiment the controller 50 is configured to control an electron-optical element of the electron-optical device 230 so as to move the beam grid 700 relative to the sample support 207 to scan the beams 701 and the sample 208 relative to each other. It is possible to perform some scanning of the beam grid 700 without requiring movement of the sample 208 relative to the electron-optical device 230. This may be referred to as an electron-optical scan or an electrical scan. A feature that corresponds to such a scan strategy may be referred to as a deflection part 750.

For example, in an embodiment the electron-optical element (i.e. which is controlled to perform the electron-optical scan) comprises a deflector configured to deflect the beam grid 700. The deflector may be a scan deflector. For example, the deflector may comprise a deflector array comprising a plurality of deflectors for deflecting respective beams 701. Alternatively or additionally, the deflector may comprise a macro deflector configured to deflect substantially all of the beams 701 of the beam grid 700. Thus, the scan deflector which may operate on all beams, or each of the beams differently, for example using the scan beam array.

A direction of actuation of the deflector may correspond to a fast direction. In an embodiment the direction of the width of an elongate strip 730 corresponds to a fast direction.

For example, in an embodiment the electron-optical element comprises the array of scan deflectors 260 of the electron-optical device 230 shown in FIG. 3 or an array of deflectors 95 of the electron-optical device, shown in and described with reference to FIG. 5, that operate as scan deflectors and comprise part of a Wien filter array. Such deflectors may be electrostatic; the electron-optical scan may be referred to as an electrostatic scan. In an embodiment the scan deflectors of the array are controlled to applying the scanning action to all of the beams of the beam grid.

In an alternative embodiment, the electron-optical element may comprise the macro scan deflector 265 of the electron-optical device 230 shown in FIG. 4. In an arrangement the effective scan range is influenced by a planar element, such as a beam shaping array which is part of or is associated with the objective lens array and is configured to shape the primary beams close to the sample surface in having apertures dimensioned smaller than other apertures of the objective lens array. Since a macro scan deflector applies the scan deflection, the electron-optical scan is the same for all beams. Additionally or alternatively, the deflector may comprise a plurality of scan deflectors 267 as shown in the electron-optical device 230 of FIG. 4. In an embodiment the scan deflectors of the array are controlled to applying the scanning action to all of the beams of the beam grid.

In an alternative embodiment the electron-optical element comprises the deflector array 95 of the electron-optical device 230 shown in FIG. 5.

In an embodiment the electron-optical device 230 is configured such that a movement of the beam grid 700 relative to the sample support 207 by control of the electron-optical element is less than a dimension of the beam area 740. For example, in an embodiment the movement of the beam grid 700 relative to the sample 208 by the electron-optical scanning may be limited for example to a dimension of at least 0.5µm, optionally at least 1µm, optionally at least 2µm and optionally at least 5µm. In an embodiment the movement of the beam grid 700 relative to the sample 208 by the electron-optical scanning may be limited for example to a dimension of at most 10µm, optionally at most 5µm, optionally at most 2µm and optionally at most 1µm. However, it is not essential for the movement of the beam grid 700 relative to the sample support 207 to be in the range of from about 0.5µm to about 10µm. In an embodiment, the movement caused by the electron-optical scan is less than the dimension of the beam area 740 by a factor of at least 2, optionally at least 5, optionally at least 10, optionally at least 20, optionally at least 50 and optionally at least 100. In an arrangement the limited electron-optical scan range may be limited to apply a selected scan strategy which uses a limited electron-optical scan range. That is the maximum scan range (e.g. for a maximum movement of electron-optical scan) may be smaller than a dimension of the beam area. The electron-optical scan range may be limited because of a physical limitation to the scan range for example the effective proximity of the scan deflector for example the array of scan deflectors 260 shown in and described with reference to FIG. 3 or the effective limited scan range of the macro-deflector 265 shown in and described with reference to FIG 4, for example together with the beam shaping array. By reducing the range of the electron-optical scan, properties of the primary beams incident on the sample surface may be expected to be improved. For example, the aberrations of the primary beams may in general be expected to increase for larger electron-optical scan ranges. By providing a limited electron-optical scan range, aberrations may be limited. An embodiment of the invention is expected to allow samples 208 to be processed efficiently without unduly reducing resolution or accuracy.

In an embodiment the electron-optical device 230 is configured such that a maximum movement of the beam grid 700 relative to the sample support 207 by control of the electron-optical element is less than a dimension of the beam area 740. In an alternative embodiment the electron-optical device 230 is configured such that a maximum movement of the beam grid 700 relative to the sample support 207 by control of the electron-optical element is equal to or greater than a dimension of the beam area 740. In an embodiment the electron-optical device 230 is configured to operate in a mode in which the movement of the beam grid 700 relative to the sample support 207 by control of the electron-optical element is selected to be less than a dimension of the beam area 740.

As shown in FIG. 16, in an embodiment at least one of the beam area patterns comprises at least one deflection part 750. The deflection part 750 has dimensions of at most the selected movement of the electron-optical scan, for example the maximum movement of the electron-optical scan. For example, when the range of the electron-optical scan is in the range of from about 0.5µm to about 10µm, then the deflection part 750 may have dimensions of in the range of from about 0.5µm to about 10µm. As shown in FIG. 16, in an embodiment the beam area pattern comprises only one deflection part 750. One deflection part 750 may be sufficient for processing the beam areas 740 particularly when the expected density of deflects is relatively high.

In an embodiment the controller 50 is configured to control the electron-optical apparatus 40 to process portions of the beam areas 740 with the respective beams 701 in accordance with the deflection part 750 of the applied beam area pattern while the sample supports 207 is stationary relative to the electron-optical device 230. The deflection part 750 may be processed without requiring any mechanical scanning of the electron-optical device 230 relative to the sample 208. The electron-optical scanning may be faster than the mechanical scanning. In other words, the time taken for the beam grid 700 to be electron-optically scanned across a feature of the dimension of a deflection part, e.g. 1 µm, may be less than the time required for the stage 209 to be mechanically actuated relative to the electron-optical device 230 by a similar distance, e.g. 1 µm. By providing the deflection part 750 that can be electron-optically scanned without requiring a mechanical scan, the speed of processing the beam area 740 may be increased. The electron-optical scanning may be referred to as fast scanning. A direction of actuation of the deflector may correspond to a fast direction. The mechanical scanning may be referred to as slow scanning. A direction of actuation of the stage 209 may correspond to a slow direction.

As shown in FIG. 17, in an embodiment at least one of the beam area patterns comprises a plurality of deflection parts 750. Each deflection part 750 has dimensions of at most the maximum movement (of the electron-optical scan). As shown in FIG. 17, in an embodiment the deflection parts 750 are distanced from each other. In order to process portions of the beam area 740 corresponding to the different deflection parts 750 of the beam area pattern, the controllers 50 may cause relative movement between the sample support 207 and the electron-optical device 230. Such a movement is stepping of the stage. Distributing the different detection parts 750 over the beam area may enable the processing of a more representative proportion of the beam area than an elongate strip. Since a beam area pattern that comprises multiple deflection parts, may require movement of the stage between so that different locations of the sample surface may be processed, that correspond to the different deflection parts within the beam area. Such a step movement incurs overhead, taking time and may reduce throughput. Considering the area of a beam area processed by such deflection parts, the associated overhead to step between the sample between different deflection parts with a beam area, and a certain likelihood in detecting defects there may be a certain number of deflection parts for a beam area pattern at which it may be more efficient to apply a mechanical scan. That is, it may be more efficient to process an elongate strip than a plurality of deflection parts. For applying a pattern with such an elongate strip, there may be a smaller stepping or even no overhead; yet the area of the beam area processed may be used to process a similar or larger area than processed by the plurality of deflection parts.

As shown in FIG. 18, in an embodiment at least one of the beam area patterns comprises elongate strips 724 that have a different direction of elongation for example as shown and described with respect to FIGs. 13 to 15. For example, as shown in FIG. 18, the elongate strips 724 may correspond to the direction along the breadth (or width) (rather than length) of the beam area 740 (where the length is greater than the width). The elongate strips 724 may be parallel to an edge of the beam area 740 as depicted, although that is not essential. In an alternative embodiment, an elongate strip may be angled obliquely (e.g. an angle of greater than 0 degrees and less than 90 degrees) to an edge of the beam area 740. In an embodiment an elongate strip may be curved, rather than straight.

As shown in FIG. 19, in an embodiment at least one beam area pattern comprises at least one elongate strip 724 and at least one differently oriented elongate strip 725. Through example, in an embodiment the elongate strip 224 and a differently oriented elongate strip 725 may be orthogonal to each other. Alternatively, a different angle other than 90 degrees may be provided between the elongate strips 724, 725. Although the different elongate strips are shown to overlap, that need not be the case. The elongate strips may, respectively, have a length that is a fraction of a dimension of the beam area.

As shown in FIG. 20, in an embodiment at least one beam area pattern comprises at least one elongate strip 724 and at least one deflection part 750. In general, any number of elongate strips and any number of deflection parts may be provided to form a beam area pattern. In an embodiment, each beam area pattern corresponds to a proportion of less than 100% of the beam area 740 (or the area of the beam area 740) processed. In an embodiment, one beam area pattern corresponds to substantially 100% of the beam area 740 being processed.

In an embodiment, mechanical scanning and electron-optical scanning are combined so as to process portions of the beam areas 740. For example, in an embodiment the controller 50 is configured to control the electron-optical apparatus 40 to process the beam areas 740 by, such as in a step (a), causing relative movement between the sample support 207 and the electron-optical device 230 in a direction parallel to a first direction. While causing such relative motion, the electron-optical device 230 may be used to repeatedly move the beam grid 700 relative to the sample support 207 in a direction parallel to a second direction. The moving of the sample 208 in the first direction may be at most a dimension of the beam area 740, for example a fraction of the dimension of a beam area 740. For example, (considering the beam area for a frame of reference) for processing portions of a beam area 740 comprising the horizontally oriented elongate strips 724 shown in FIG. 13, the first direction may be the left-right direction (i.e. the horizontal direction of FIG. 13). The second direction may be the up-down direction in the orientation shown in FIG. 13. It is not essential for the first direction and the second direction to be perpendicular to each other. The first direction may be angled oblique to the second direction. Each beam 701 is scanned in the direction parallel to the first direction and repeatedly in the direction parallel to the second direction to process portions of the beam areas 740 with the respective beams 701 in accordance with an elongate strip 724 of the applied beam area pattern. A mechanical scan is performed in the first direction while applying the electron-optical scan. In an embodiment the electron-optical scan is perpendicular to the mechanical scan, although the orientation of the electron-optical scan can be in any direction. In an embodiment, relative scanning of the beam over the elongate strip 724 by the mechanical scanning and electron-optical scanning may comprise:. electron-optical scanning substantially perpendicularly to the first direction, substantially parallel to the first direction, and/or substantially at a direction angled with respect to the first direction such as at 45 degrees. The electron-optical scanning may comprise electron-optical scanning in any direction relative to the first direction.

Desirably the direction of the electron-optical scan is consistent during processing of a beam area for example at least parts of the beam area corresponding to an applied beam area pattern. Desirably the direction of the electron-optical scan applied to process a beam area, is in the same direction (for example in a common direction) as the electron-optical scan applied to a process a different region on the same sample or a different sample. The data sets from the different beam areas may then be compared together for assessment purposes such as defect inspection in a die-to-die mode. When the beam area pattern comprises a plurality of elongate strips 724, each beam 701 scans portions of the beam area 740 by performing multiple mechanical scans in one direction of the beam area 740, while electron-optically scanning relative to the mechanical scan, for example deflecting perpendicular to the mechanical scan. In order to process the portions corresponding to the whole of the applied beam area pattern, multiple scans may be done, each shifted perpendicular to the mechanical scan direction over the size of the gap 731. The shifting between the different elongate strips may be achieved by moving the stage or stepping the sample. The stepping movement may be considered an overhead which has the potential to reduce throughput.

In an embodiment, the relative scanning of the beam over the elongate strips of the beam area of intended pattern (for example at a first beam area) and the relative scanning of the beam over beam area of the beam of a different region on the same sample or a different sample (for example at a second beam area) are in the common direction (e.g., in the same direction or in a similar direction Such relative scanning comprises electron-optical scanning of the beam. Arranging for the electron-optical scanning to be in the common direction or near to the common direction can be achieved in various ways. For example, in one embodiment, an average direction of the electron-optical scanning is substantially parallel to the first direction during the relative scanning of the elongate strip at the first beam area and during the relative scanning of the elongate strip at the second beam area. In an arrangement the the electron-optical scanning of the elongate strip may have an average direction of that is substantially parallel to (or within +/- 20 degrees of) the direction of the mechanical scan. Full coverage of such an elongate strip, for example a horizontally elongate strip 724) may be achieved in this scenario by scanning the beam in the first direction (for example in which the direction of the mechanical scan) or near to the first direction at multiple different positions across the width of the elongate strip. The process is repeated at different positions along the first direction. If the width of the elongate strip is covered before the mechanical scan has advanced in the first direction by more than a range of the electrostatic scan then full coverage of the elongate strip can be achieved. For a vertically elongate strip 725, the direction of the electron-optical scanning may be in or substantially in the same direction as the mechanical scan as described for the horizontally elongate strip 724 except the first direction may correspond to the direction of the mechanical scan for example be in a vertical direction. In an arrangement of the relative scanning of the second beam area may be angled or even orthogonal to the relative scanning of the first beam area. for example An example of such relative scanning is depicted in FIG. 19and discussed in further detail below with reference to **FIG. 19****.** In such an arrangement the average direction of the electron-optical scanning of the elongate strip (for example a vertically elongate strip 725) may have an average direction of the electron-optical scanning that is substantially perpendicular to (or within +/- 20 degrees of being perpendicular to) the direction of the mechanical scan. The direction of the electron-optical scanning for the vertically elongate strip of the second beam area may be in a similar or substantially the same direction as the horizontally elongate strip of the first beam area. In another embodiment, which may be implemented in an analogous manner, an average direction of the electro-optical scanning is substantially parallel to the second direction during the relative scanning of elongate strip of the first beam area and during the relative scanning of the elongate strip of the second beam area. In another embodiment, an average direction of the electrostatic scanning is at substantially 45 degrees to the first direction during the relative scanning of the elongate strip of the first beam area and during the relative scanning of the elongate strip of the second beam area.

In an embodiment the controller is configured to control the electron-optical apparatus 40 to process portions of the beam areas 740 by, one or more times, such as in a step (b), causing relative movement between the sample support 207 and the electron-optical device in a direction oblique or perpendicular to the first direction. For example, in a step (c), step (a) may be repeated. That is, the mechanical scan is combined with the electron-optical scan to process a further portion of the beam area 740 with the respective beam 701 in accordance with a further elongate strip 724 of a plurality of elongate strips 724 of the applied beam area pattern.

The relative movement, such as in step (b), between the sample support 207 and the electron-optical device may be a distance at least the width of the elongate strip 730, for example a distance a factor times the width of the elongate strip 730, such as a multiple of the width. The displacement may be multiple widths. The multiple may be a number so that the elongate strips 730 are positioned differently over the corresponding regions 732 on the different samples 208 so that on scanning of beam areas 740 of all the different samples 208 of the number of samples 208, the full beam area of a beam 701 in the beam grid 700 is scanned. In other words, the electron-optical apparatus 40 may be configured to skip a number of strips between each scanned strip. The selected strip scanned in a sample may be different for each of a number of different samples so that on scanning the same region of all of the samples, a full beam area of the region is scanned.

As shown in FIG. 19, for example, in an embodiment at least one of the beam area patterns comprises differently oriented elongate strips 724, 725. In an embodiment the controller 50 is configured to control the electron-optical apparatus 40 to process portions of the beam areas 740, such as in a step (d), by causing relative movement between the sample support 207 and the electron-optical device 230 in a direction parallel to a third direction different from the first direction. The causing of such relative movement may be while using the electron-optical device 230 to repeatedly move the beam grid 700 relative to the sample support 207 in a direction parallel to a fourth direction. For example, in order to scan a portion corresponding to the differently oriented elongate strips 725 shown in FIG. 19, the third direction may be the up-down direction and the fourth direction may be the left-right direction. Each beam 701 may be scanned in the direction parallel to the third direction and repeatedly in the direction parallel to the fourth direction to process portions of the beam areas 740 with the respective beams 701 in accordance with the differently oriented elongate strip 725 of the applied beam area pattern. In an embodiment the third direction is the second direction and/or the fourth direction is the first direction. When the third direction is the second direction and the fourth direction is the first direction, then the differently oriented elongate strips 724, 725 may be perpendicular to each other.

For example, in an embodiment the controller 50 is configured to actuate the stage 209 so as to move the sample 208 relative to the electron-optical device 230 so as to perform the mechanical scan. In an embodiment the controller 50 is configured to control actuation of a beam of electrons by operation of a deflector such as by applying one or more potentials electron-optical element such as a deflector 260 of the electron-optical device 230, or to controlling current supplied to an electromagnetic element such as the deflector 265, so as to repeatedly move the beam grid 700 relative to the sample 208, thereby performing the electron-optical scan.

In an embodiment the controller is configured to control the electron-optical apparatus 40 to process portions of the beam areas 740 by, one or more times, such as in a step (e). Each event of such processing of portions of the beam areas 740 may be by causing relative movement between the sample support 207 and the electron-optical device 230 in a direction oblique or perpendicular to the third direction. In a step (f) the causing relative movement between the sample support 207 and the electron-optical device 230 in a direction parallel to a third direction different from the first direction may be while repeatedly moving the beam grid 700 relative to the sample support 207 in a direction parallel to a fourth direction may be repeated, for example in repeating step (d). The repeating of causing relative movement may process a further portion of the beam areas 740 with the respective beams 701 in accordance with a further differently oriented elongate strip of a plurality of differently oriented elongate strips of the applied beam area pattern. The beam area pattern shown in FIG. 19 shows one horizontally elongate strip 724 and one vertical elongate strip 725. In an embodiment at least one of the beam area patterns comprises a plurality of horizontal elongate strips 724 and a plurality of vertical elongate strips 725. The terms horizontal and vertical refer to the orientation as shown in FIG. 19. The horizontal and vertical terminology may refer to an X direction and a Y direction, for example. The direction of the differently orientated strips shown in and described with reference to FIG. 19 may be different from orthogonal.

In an embodiment the controller is configured to control the electron-optical apparatus 40 to process portions of the beam areas 740 by, such as in step (g), using the electron-optical device 230 to repeatedly move the beam grid 700 relative to the sample support 207 in a direction parallel to a first direction and in a direction parallel to a second direction, to process portions of the beam areas 740 with the respective beams 701 in accordance with a deflection part 750 of the applied beam area pattern. Such using of the electron optical device 230 may be while maintaining relative position between the sample support 207 and the electron-optical device 230. The deflection part 750 may be processed while the stage 209 remains stationary. For example, in an embodiment the controller 50 may be configured to control an electron-optical element such as a deflector of the electron-optical device 240 so as to process the deflection part 750. The deflection part 750 may be processed with a deflection only scan. A deflection only scan is a scan that comprises only an electron-optical scan without any mechanical scan.

In an embodiment the controller 50 is configured to control the electron-optical apparatus 40 to process portions of the beam areas 740 by, one or more times, for example in a step(h). Such control of the electron-optical apparatus may be by causing relative movement between the sample support 207 and the electron-optical device 230. In such control of the electron-optical apparatus, such as in step (i) there may be repeating, such as of step (g), to scan a further portion of the beam area 740 with the respective beams 701 in accordance with a further deflection part of a plurality of deflection parts 750 of the applied beam area pattern. As shown in FIG. 17, in an embodiment the beam area pattern comprises a plurality of deflection parts 750. The controller 50 may actuate the stage 209 between portions of the beam area 740 corresponding to the different deflection parts 750. The different portions of the beam area 740 may be processed according to the different deflection parts 750 of the beam area pattern. An electron-optical scan may be used to scan a portion corresponding to a first deflection part 750. A mechanical scan may then be performed before scanning another portion of the beam area 740 corresponding to a second deflection part 750. A plurality of portions corresponding to a plurality of deflection parts 750 of the applied beam area pattern may be successively processed.

In an embodiment the controller 50 is configured to control the electron-optical apparatus 40 to cause relative movement between the sample support 207 and the electron-optical device 230 by a distance greater than a dimension of the region 730 in a direction across the beam grid 700 such that the electron-optical device 230 faces a subsequent region 732 of the sample surface. This relative movement may be performed when the previous region 732 is only partially processed. The applied beam area pattern may be associated with a proportion of the beam area 740 being processed, the proportion being less than 100%. As a result, the region 732 is only partially processed. The stage 209 may then be moved so as to allow a subsequent region 732 (e.g. of a plurality of regions 732 as shown in FIG. 9) to be processed. Beam areas 740 of the subsequent region 732 may then be partially processed in accordance with the applied beam area pattern (or a different selected beam area pattern). By only partially processing each region 732, the regions 732 may be processed more quickly, for example sufficient for the use case or application.

In an embodiment, the electron-optical apparatus 40 is configured to displace or move the stage (e.g. step) between different relative positions between the sample 208 and the beam grid 700 by a distance larger than a dimension of the region 732. The region 732 may correspond to the field of view of the beam grid 700 on the sample surface. The electron-optical apparatus 40 may be configured to step between different regions 732.

In an embodiment, the different regions correspond to different fields such as dies on the sample surface. In an embodiment, the electron-optical apparatus 40 is configured to displace between the different fields before the region 732 is fully processed. In an embodiment, the electron-optical apparatus 40 is configured to displace back to the region 732 to continue processing the region 732. In an embodiment, the controller 50 is configured to control the actuatable stage 209 to displace between the different relative positions between the sample 208 and the beam grid 700.

In an embodiment, the portions of the sample surface are processed so as to assess the sample 208. For example, defects of structures of the sample 208 may be identified. Additionally or alternatively, one or more properties of the sample 208 may be measured.

In an embodiment the controller 50 is configured to assess the sample 208 based on results of the processing. For example, the controller 50 may be configured to assess the sample 208 based on an output of the detector array 240 detecting signal electrons such as in response to the primary beams that are scanned over the sample surface. The detector array may output one or more datasets corresponding to one or more respective images. In an embodiment the controller 50 is configured to assess the sample 208 when the region 732 is only partially scanned. The controller 50 may be configured to process data output by the detector array 240 without the region 732 being completely processed. An embodiment of the invention is expected to speed up assessment of a sample 208. In an embodiment the invention is expected to provide a sufficient area of processed sample surface (or a sufficient sample processed area of the sample) for assessment of the sample for one or more use cases. Use of a scanning strategy that achieves processing such a sufficient sample area may account for even balance such processing with the time for scanning for an optimized or even minimized throughput time. The scanning strategy may account for, optimally reduce even minimize overhead time, such as in stepping between different parts within the beam area. The beam area pattern may be selected for a number of options with a low number of steps optionally minimum number of steps within the beam area (when being applied). In an embodiment the assessment of the sample 208 comprises assessment of variation of one or more properties across the sample 208. The regions 732 may be selected to be at different positions across the sample 208.

References to upper and lower, up and down, above and below, etc. should be understood as referring to directions parallel to the (typically but not always vertical) upbeam and downbeam directions of charged particle beams impinging on the sample 208. The terms upbeam and downbeam are relative directions in the electron-optical apparatus. It is not intended that a beam is required to be present for these terms to have meaning; for example it is intended that these terms are applicable when the beam of electrons is not present for example during servicing of the electron-optical device. Thus, references to upbeam and downbeam are intended to refer to directions in respect of the beam path independently of any present gravitational field and presence of a beam of electrons at specific moment in time.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

The term "image" used herein is intended to refer to any array of values wherein each value relates to a sample of a location and the arrangement of values in the array corresponds to a spatial arrangement of the sampled locations. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Aspects of the invention are set out in the following numbered clauses.

Clause 1. A charged particle-optical apparatus comprising:a charged particle-optical device configured to direct a beam grid of beams of charged particles toward a region of a sample surface of a sample; a sample support configured to support the sample; and a controller configured to control the charged particle-optical apparatus to selectively apply one of a plurality of predetermined beam area patterns so as to process portions of respective beam areas of the region with respective beams in accordance with the applied beam area pattern; wherein the beam area patterns are associated with respective proportions of the beam areas being processed, and at least one of the beam area patterns comprises at least one elongate strip.

Clause 2. The charged particle-optical apparatus of clause 1, wherein the elongate strip has a length greater than a width by a factor of at least 2, optionally at least 5 and optionally at least 10.

Clause 3. The charged particle-optical apparatus of clause 1 or 2, wherein at least one of the beam area patterns comprises a plurality of elongate strips.

Clause 4. The charged particle-optical apparatus of clause 3, wherein the plurality of elongate strips are distanced from each other.

Clause 5. The charged particle-optical apparatus of clause 3, wherein the plurality of elongate strips adjoin each other.

Clause 6. The charged particle-optical apparatus of any of clauses 3-5, wherein the plurality of elongate strips have a length less than a pitch of the beams in the beam grid.

Clause 7. The charged particle-optical apparatus of any of clauses 3-5, wherein the plurality of elongate strips have a length at most equal to a pitch of the beams in the beam grid.

Clause 8. The charged particle-optical apparatus of any of clauses 3-7, wherein one or more of the elongate strips positioned across the corresponding beam area have a combined length at most equal to a pitch of the beams in the beam grid.

Clause 9. The charged particle-optical apparatus of any of clauses 3-8, wherein a plurality of the elongate strips have different lengths.

Clause 10. The charged particle-optical apparatus of any of clauses 3-9, wherein a plurality of the elongate strips have different orientations across the corresponding beam area.

Clause 11. The charged particle-optical apparatus of any preceding clause, wherein the beam area patterns of the different beam areas of a beam grid are the same.

Clause 12. The charged particle-optical apparatus of any preceding clause, wherein the controller is configured to control relative motion between the paths of the beams of the the grid and the sample surface to scan the beams and the sample relative to each other.

Clause 13. The charged particle-optical apparatus of clause 12, wherein the controller is configured to control a charged particle-optical element of the charged particle-optical device so as to move the beams of the beam grid relative to the sample support to scan the beams and the sample relative to each other.

Clause 14. The charged particle-optical apparatus of clause 13, wherein the charged particle-optical element comprises a deflector configured to deflect the beam grid.

Clause 15. The charged particle-optical apparatus of clause 14, wherein a direction of actuation of the deflector corresponds to a fast direction.

Clause 16. The charged particle-optical apparatus of clause 14 or 15, wherein the deflector comprises a deflector array comprising a plurality of deflectors for deflecting respective beams.

Clause 17. The charged particle-optical apparatus of any of clauses 13-16, wherein the charged particle-optical device is configured such that a movement of the beam grid relative to the sample support by control of the charged particle-optical element is less than a dimension of the beam area.

Clause 18. The charged particle-optical apparatus of clause 17, wherein the movement of the beam grid is less than the dimension of the beam area by a factor of at least 2, optionally at least 5, optionally at least 10, optionally at least 20, optionally at least 50 and optionally at least 100.

Clause 19. The charged particle-optical apparatus of clause 17 or 18, wherein at least one of the beam area patterns comprises at least one deflection part having dimensions of at most the movement of the beam grid.

Clause 20. The charged particle-optical apparatus of clause 19, wherein the controller is configured to control the charged particle-optical apparatus to process portions of the beam areas with the respective beams in accordance with the deflection part of the applied beam area pattern while the sample support is in motion or stationary relative to the charged particle-optical device.

Clause 21. The charged particle-optical apparatus of clause 19 or 20, wherein at least one of the beam area patterns comprises a plurality of deflection parts each having dimensions of at most the movement of the beam grid.

Clause 22. The charged particle-optical apparatus of clause 16, wherein the deflection parts are distanced from each other.

Clause 23. The charged particle-optical apparatus of any of clauses 14-22, wherein the deflector has a scan range corresponding to a width of the elongate strip, optionally in the direction of the width of the elongate strip and/or in the direction of the elongate strip.

Clause 24. The charged particle-optical apparatus of clause 23, wherein the direction of the width of the elongate strip corresponds to a fast direction.

Clause 25. The charged particle-optical apparatus of any preceding clause, wherein the controller is configured to cause relative movement between the sample support and the charged particle-optical device to scan the beams and the sample relative to each other.

Clause 26. The charged particle-optical apparatus of clause 25, wherein a direction of the relative movement corresponds to a slow direction.

Clause 27. The charged particle-optical apparatus of clause 25 or 26, wherein a dimension of an elongate strip in a direction of the strip corresponds to the relative movement.

Clause 28. The charged particle-optical apparatus of any of clauses 25-27, configured such that during processing of a beam area, a relative movement between the sample support and the charged particle-optical device is at most a dimension of the beam area.

Clause 29. The charged particle-optical apparatus of any of clauses 25-28, comprising: an actuatable stage configured to support the sample, wherein the controller is configured to cause the relative movement by actuating the actuatable stage.

Clause 30. The charged particle-optical apparatus of clause 29, wherein the actuatable stage is configured to support the sample support.

Clause 31. The charged particle-optical apparatus of any preceding clause, wherein, so as to process a plurality of features of the beam area pattern positioned across a corresponding beam area in a direction of the width of the elongate strip, the charged particle-optical apparatus is configured to displace between different relative positions between the sample and the beam grid.

Clause 32. The charged particle-optical apparatus of clause 31, wherein the charged particle-optical apparatus is configured to displace between different relative positions between the sample and the beam grid so that the beam grid remains within the region on the same sample surface.

Clause 33. The charged particle-optical apparatus of clause 31 or 32, wherein the different relative positions corresponding to different features of the beam area pattern.

Clause 34. The charged particle-optical apparatus of any preceding clause, wherein, so as to process a beam area of a different region, the charged particle-optical apparatus is configured to displace between different relative positions between the sample and the beam grid by a distance larger than a dimension of the region.

Clause 35. The charged particle-optical apparatus of clause 34, wherein the different region corresponds to a different field.

Clause 36. The charged particle-optical apparatus of clause 35, wherein the different field is a die on the sample surface.

Clause 37. The charged particle-optical apparatus of any of clauses 34-36, wherein the charged particle-optical apparatus is configured to displace between the different relative positions before the region is fully processed.

Clause 38. The charged particle-optical apparatus of clause 37, wherein the charged particle-optical apparatus is configured to displace back to the region to continue processing the region.

Clause 39. The charged particle-optical apparatus of any of clauses 31-38, wherein the controller is configured to control an actuatable stage of the charged particle-optical apparatus to displace between the different relative positions between the sample and the beam grid.

Clause 40. The charged particle-optical apparatus of any preceding clause, wherein the controller is configured to, when the region is only partially scanned, assess the sample based on results of the processing.

Clause 41. The charged particle-optical apparatus of clause 40, wherein the assessment of the sample comprises assessment of variation of one or more properties across the sample.

Clause 42. The charged particle-optical apparatus of any preceding clause, wherein at least one of the proportions is at most 50%, optionally at most 20%, optionally at most 10%, optionally at most 5%, optionally at most 2% and optionally at most 1% of the beam area.

Clause 43. A method of processing a sample with beams of charged particles, the method comprising: directing a beam grid of beams of charged particles toward a sample using a charged particle-optical device; and selectively applying one of a plurality of predetermined beam area patterns so as to process portions of beam areas of a region of a sample surface of the sample with respective beams in accordance with the applied beam area pattern; wherein the beam area patterns are associated with respective proportions of the beam areas being processed, and at least one of the beam area patterns comprises at least one elongate strip.

Clause 44. The method of clause 43, comprising: processing another sample with the charged particle-optical device when the region remains only partially processed.

Clause 45. The method of clause 43 or 44, comprising processing the beam areas by: moving the sample in a direction parallel to a first direction while repeatedly moving the beam grid relative to the sample in a direction parallel to a second direction, thereby scanning each beam in the direction parallel to the first direction and repeatedly in the direction parallel to the second direction to process portions of the beam areas with the respective beams in accordance with an elongate strip of the applied beam area pattern.

Clause 46. The method of clause 45, wherein the moving of the sample in the first direction is at most a dimension of the beam area.

Clause 47. The method of clause 46, wherein the moving of the sample in the first direction is a fraction of the dimension of a beam area.

Clause 48. The method of any of clauses 45-47, comprising processing portions of the beam areas by, one or more times: moving the sample in a direction oblique or perpendicular to the first direction; and repeating the step of moving the sample in a direction parallel to a first direction to process a further portion of the beam areas with the respective beams in accordance with a further elongate strip of a plurality of elongate strips of the applied beam area pattern.

Clause 49. The method of clause 48, wherein the sample is moved in the direction oblique or perpendicular to the first direction a distance at least the width of the elongate strip.

Clause 50. The method of clause 49, wherein the sample is moved in the direction oblique or perpendicular to the first direction a distance that is a factor times the width of the elongate strip.

Clause 51. The method of clause 50, wherein the sample is moved in the direction oblique or perpendicular to the first direction a distance that is a multiple of the width of the elongate strip.

Clause 52. The method of any of clauses 45-51, comprising processing portions of the beam areas by: moving the sample in a direction parallel to a third direction different from the first direction while repeatedly moving the beam grid relative to the sample in a direction parallel to a fourth direction, thereby scanning each beam in the direction parallel to the third direction and repeatedly in the direction parallel to the fourth direction to process portions of the beam areas with the respective beams in accordance with a differently-oriented elongate strip of the applied beam area pattern.

Clause 53. The method of clause 52, comprising processing portions of the beam areas by, one or more times: moving the sample in a direction oblique or perpendicular to the third direction; and repeating the step of moving the sample in the direction parallel to the third direction to process a further portion of the beam areas with the respective beams in accordance with a further differently-oriented elongate strip of a plurality of differently-oriented elongate strips of the applied beam area pattern.

Clause 54. The method of clause 52 or 53, wherein the third direction is the second direction and/or the fourth direction is the first direction.

Clause 55. The method of any of clauses 43-54, comprising processing portions of the beam areas by: while maintaining position of the sample, repeatedly moving the beam grid relative to the sample in a direction parallel to a first direction and in a direction parallel to a second direction, to process portions of the beam areas with the respective beams in accordance with a deflection part of the applied beam area pattern.

Clause 56. The method of clause 55, comprising processing portions of the beam areas by, one or more times: moving the sample; and repeating the step of repeatedly moving the beam grid relative to the sample in the direction parallel to the first direction and in the direction parallel to the second direction to scan a further portion of the beam areas with the respective beams in accordance with a further deflection part of a plurality of deflection parts of the applied beam area pattern.

Clause 57. The method of any of clauses 43-56, wherein substantially corresponding portions of the beam areas are processed.

Clause 58. The method of any of clauses 43-57, comprising: when the region is only partially processed, moving the sample by a distance greater than a dimension of the region in a direction across the beam grid; and process portions of respective beam areas of a subsequent region with respective beams in accordance with the applied beam area pattern.

Clause 59. The method of clause 58, comprising processing corresponding portions of the region and the subsequent region.

Clause 60. A method of processing at least a part of sample surface with a beam grid of beams of charged particles toward a region of a sample surface of a sample, each beam being assigned a beam area of the region, the method comprising: defining a pattern per beam area comprising an elongate strip; and simultaneously scanning the beams of the beam grid relative to each other so the beams scan over the respective beam areas to process a surface of the beam area corresponding to the pattern.

Clause 61. The method of clause 60, wherein the determining of the beam pattern is based on a given particle detection probability and target area of a sample surface, the target area comprising one or more regions of the sample surface.

Clause 62. The method of clause 60 or 61, wherein the determining of the beam pattern comprises defining a target process area as a proportion of the target area based on the particle detection probability for ensuring the chance of detecting a particle is above a detection threshold.

Clause 63. The method of any of clauses 60-62, wherein the determining of the beam pattern comprises distributing the target process area over the different regions within the target area as a respective scan area, desirably equally per region.

Clause 64. The method of any of clauses 60-63, wherein the determining of the beam pattern comprises distributing the scan area equally to each beam area of the region as the pattern.

Clause 65. The method of any of clauses 60-64, wherein the determining of the beam pattern comprises determining the pattern based on the least number of steps (desirably by as a step motion by an actuated stage), desirably at least one of the steps is at an end of the elongate strip.

Clause 66. A computer program provided in the form of media storing computer readable instructions that, when read by a computer, cause the computer to instruct a charged particle-optical apparatus to perform a method of processing a sample with beams of charged particles, the method comprising: directing a beam grid of beams of charged particles toward a sample using a charged particle-optical device; and selectively applying one of a plurality of predetermined beam area patterns so as to process portions of beam areas of a region of a sample surface of the sample with respective beams in accordance with the applied beam area pattern; wherein the beam area patterns are associated with respective proportions of the beam areas being processed, and at least one of the beam area patterns comprises at least one elongate strip.

Clause 67. The computer program of clause 66, the method comprising: processing another sample with the charged particle-optical device when the region remains only partially processed.

Clause 68. The computer program of clause 66 or 67, the method comprising processing the beam areas by: moving the sample in a direction parallel to a first direction while repeatedly moving the beam grid relative to the sample in a direction parallel to a second direction, thereby scanning each beam in the direction parallel to the first direction and repeatedly in the direction parallel to the second direction to process portions of the beam areas with the respective beams in accordance with an elongate strip of the applied beam area pattern.

Clause 69. The computer program of clause 68, wherein the moving of the sample in the first direction is at most a dimension of the beam area.

Clause 70. The computer program of clause 69, wherein the moving of the sample in the first direction is a fraction of the dimension of a beam area.

Clause 71. The computer program of any of clauses 68-70, the method comprising processing portions of the beam areas by, one or more times: moving the sample in a direction oblique or perpendicular to the first direction; and repeating the step of moving the sample in a direction parallel to a first direction to process a further portion of the beam areas with the respective beams in accordance with a further elongate strip of a plurality of elongate strips of the applied beam area pattern.

Clause 72. The computer program of clause 71, wherein the sample is moved in the direction oblique or perpendicular to the first direction a distance at least the width of the elongate strip.

Clause 73. The computer program of clause 72, wherein the sample is moved in the direction oblique or perpendicular to the first direction a distance that is a factor times the width of the elongate strip.

Clause 74. The computer program of clause 73, wherein the sample is moved in the direction oblique or perpendicular to the first direction a distance that is a multiple of the width of the elongate strip.

Clause 75. The computer program of any of clauses 68-74, the method comprising processing portions of the beam areas by: moving the sample in a direction parallel to a third direction different from the first direction while repeatedly moving the beam grid relative to the sample in a direction parallel to a fourth direction, thereby scanning each beam in the direction parallel to the third direction and repeatedly in the direction parallel to the fourth direction to process portions of the beam areas with the respective beams in accordance with a differently-oriented elongate strip of the applied beam area pattern.

Clause 76. The computer program of clause 75, the method comprising processing portions of the beam areas by, one or more times: moving the sample in a direction oblique or perpendicular to the third direction; and repeating the step of moving the sample in the direction parallel to the third direction to process a further portion of the beam areas with the respective beams in accordance with a further differently-oriented elongate strip of a plurality of differently-oriented elongate strips of the applied beam area pattern.

Clause 77. The computer program of clause 75 or 76, wherein the third direction is the second direction and/or the fourth direction is the first direction.

Clause 78. The computer program of any of clauses 66-77, the method comprising processing portions of the beam areas by: while maintaining position of the sample, repeatedly moving the beam grid relative to the sample in a direction parallel to a first direction and in a direction parallel to a second direction, to process portions of the beam areas with the respective beams in accordance with a deflection part of the applied beam area pattern.

Clause 79. The computer program of clause 78, the method comprising processing portions of the beam areas by, one or more times: moving the sample; and repeating the step of repeatedly moving the beam grid relative to the sample in the direction parallel to the first direction and in the direction parallel to the second direction to scan a further portion of the beam areas with the respective beams in accordance with a further deflection part of a plurality of deflection parts of the applied beam area pattern.

Clause 80. The computer program of any of clauses 66-79, wherein substantially corresponding portions of the beam areas are processed.

Clause 81. The computer program of any of clauses 66-80, the method comprising: when the region is only partially processed, moving the sample by a distance greater than a dimension of the region in a direction across the beam grid; and process portions of respective beam areas of a subsequent region with respective beams in accordance with the applied beam area pattern.

Clause 82. The computer program of clause 81, the method comprising processing corresponding portions of the region and the subsequent region.

Clause 83. A computer program provided in the form of media storing computer readable instructions that, when read by a computer, cause the computer to instruct a charged particle-optical apparatus to perform a method of processing at least a part of a sample surface with a beam grid of beams of charged particles toward a region of a sample surface of a sample, each beam being assigned a beam area of the region, the method comprising: defining a pattern per beam area comprising an elongate strip; and simultaneously scanning the beams of the beam grid relative to each other so the beams scan over the respective beam areas to process a surface of the beam area corresponding to the pattern.

Clause 84. The computer program of clause 83, wherein the determining of the beam pattern is based on a given particle detection probability and target area of a sample surface, the target area comprising one or more regions of the sample surface.

Clause 85. The computer program of clause 83 or 84, wherein the determining of the beam pattern comprises defining a target process area as a proportion of the target area based on the particle detection probability for ensuring the chance of detecting a particle is above a detection threshold.

Clause 86. The computer program of any of clauses 83-85, wherein the determining of the beam pattern comprises distributing the target process area over the different regions within the target area as a respective scan area, desirably equally per region.

Clause 87. The computer program of any of clauses 83-86, wherein the determining of the beam pattern comprises distributing the scan area equally to each beam area of the region as the pattern.

Clause 88. The computer program of any of clauses 83-87, wherein the determining of the beam pattern comprises determining the pattern based on the least number of steps (desirably by as a step motion by an actuated stage), desirably at least one of the steps is at an end of the elongate strip.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged particle-optical apparatus comprising:
a charged particle-optical device configured to direct a beam grid of beams of charged particles toward a region of a sample surface of a sample;
a sample support configured to support the sample; and
a controller configured to control the charged particle-optical apparatus to selectively apply one of a plurality of predetermined beam area patterns so as to process portions of respective beam areas of the region with respective beams in accordance with the applied beam area pattern;
wherein the beam area patterns are associated with respective proportions of the beam areas being processed, and at least one of the beam area patterns comprises at least one elongate strip.

2. The charged particle-optical apparatus of claim 1, wherein at least one of the beam area patterns comprises a plurality of elongate strips.

3. The charged particle-optical apparatus of claim 2, wherein the plurality of elongate strips are distanced from each other; or wherein the plurality of elongate strips adjoin each other.

4. The charged particle-optical apparatus of claim 2 or 3 wherein the plurality of elongate strips have a length less than a pitch of the beams in the beam grid; or wherein the plurality of elongate strips have a length at most equal to a pitch of the beams in the beam grid.

5. The charged particle-optical apparatus of any of claims 2-4, wherein a plurality of the elongate strips have different lengths and/or wherein a plurality of the elongate strips have different orientations across the corresponding beam area.

6. The charged particle-optical apparatus of any preceding claim, wherein the beam area patterns of the different beam areas of a beam grid are the same.

7. The charged particle-optical apparatus of any preceding claim, wherein the elongate strip has a length greater than a width by a factor of at least 2, optionally at least 5 and optionally at least 10.

8. The charged particle-optical apparatus of any preceding claim, wherein the controller is configured to control relative motion between the paths of the beams of the the grid and the sample surface to scan the beams and the sample relative to each other.

9. The charged particle-optical apparatus of claim 8, wherein the controller is configured to control a charged particle-optical element of the charged particle-optical device so as to move the beams of the beam grid relative to the sample support to scan the beams and the sample relative to each other.

10. The charged particle-optical apparatus of claim 9, wherein the charged particle-optical element comprises a deflector configured to deflect the beam grid.

11. The charged particle-optical apparatus of claim 9 or 10, wherein the charged particle-optical device is configured such that a movement of the beam grid relative to the sample support by control of the charged particle-optical element is less than a dimension of the beam area.

12. The charged particle-optical apparatus of any preceding claim, wherein the controller is configured to cause relative movement between the sample support and the charged particle-optical device to scan the beams and the sample relative to each other.

13. The charged particle-optical apparatus of any preceding claim, wherein, so as to process a plurality of features of the beam area pattern positioned across a corresponding beam area in a direction of the width of the elongate strip, the charged particle-optical apparatus is configured to displace between different relative positions between the sample and the beam grid.

14. The charged particle-optical apparatus of any preceding claim, wherein the controller is configured to, when the region is only partially scanned, assess the sample based on results of the processing.

15. A method of processing a sample with beams of charged particles, the method comprising:
directing a beam grid of beams of charged particles toward a sample using a charged particle-optical device; and
selectively applying one of a plurality of predetermined beam area patterns so as to process portions of beam areas of a region of a sample surface of the sample with respective beams in accordance with the applied beam area pattern;
wherein the beam area patterns are associated with respective proportions of the beam areas being processed, and at least one of the beam area patterns comprises at least one elongate strip.
